# EUROPEAN PATENT APPLICATION

(11) **EP 4 550 989 A1**
(43) Date of publication of application: **07.05.2025**
(21) Application number: 24209304.5
(22) Date of filing: 28.10.2024
(51) Int. Cl.: H10K 59/131, H10K 59/65

(54) **DISPLAY DEVICE**

(30) Priority: 30.10.2023 KR 20230146654
(71) Applicant: Samsung Display Co., Ltd., Yongin-si, Gyeonggi-do 17113 (KR)
(72) Inventor: LEE, Kyunghoe, 17113 Yongin-si (KR); LEE, Cheol-Gon, 17113 Yongin-si (KR)
(74) Representative: Taor, Simon Edward William

(57) **Abstract**

A display device includes a base layer including a display area including a first area and a second area, and a non-display area including a chip area and a pad area located farther from the display area than the chip area. The display device includes a first pixel in the first area, a first optical sensor in the second area, a first data line extending from the chip area to the first area in the second direction and electrically connecting the first pixel to the driving chip, a first readout line extending from the pad area to the second area in the second direction and electrically connected to the first optical sensor; and a power line extending from the pad area in the second direction to overlap the first readout line in the non-display area.

## Description

### BACKGROUND

The present disclosure relates to a display device, and for example, to a display device including an optical sensing element.

An electronic apparatus such as smartphones, digital cameras, laptop computers, navigations, and smart televisions, which provide an image to a user, includes a display device for displaying an image. A display device includes a display panel that generates an image, an input unit such as an input sensor, a camera that photographs an external image, and one or more suitable sensors.

The input sensor is arranged on the display panel to detect user's touch. The sensors may include a fingerprint sensor, a proximity sensor, and an optical sensor. In the sensors, the fingerprint sensor detects a user's fingerprint provided on the display panel.

### SUMMARY

The present disclosure provides a display device having an increasing light sensing area.

One or more embodiments of the present disclosure provide a display device that includes: a base layer including a display including a first area and a second area adjacent to the first area in a first direction, and a non-display area including a chip area and a pad area located farther from the display area than the chip area in a second direction crossing the first direction; a driving chip in the chip area; a first pixel in the first area and including a first light emitting element; a first optical sensor in the second area; a first data line extending from the chip area to the first area in the second direction and configured to electrically connect the first pixel to the driving chip; a first readout line extending from the pad area to the second area in the second direction and electrically connected to the first optical sensor; and a power line extending from the pad area in the second direction overlapping the first readout line in the non-display area. In one or more embodiments, the first data line and the first readout line do not overlap each other in the non-display area, and the first readout line and the power line may be at different layers in an area of the non-display area on which the first readout line and the power line overlap each other.

In one or more embodiments of the present disclosure, a display device includes: a base layer including a display area and a sealing area defined by a first direction and a second direction crossing each other, a non-display area comprising a pad area located farther from the display area than the sealing area being from the display area in the second direction, and a chip area located between the sealing area and the pad area; a first inorganic layer, a second inorganic layer, a third inorganic layer, a fourth inorganic layer, a fifth inorganic layer, and a sixth inorganic layer on the base layer, overlapping the display area and the non-display area, and sequentially laminated; a first organic layer, a second organic layer, and a third organic layer on the sixth inorganic layer, exposing a contact area of the sixth inorganic layer in the sealing area, and sequentially laminated; a driving chip in the chip area; a pixel in the display area and including a shielding electrode, a dummy electrode, a first transistor, a second transistor, and a light emitting element; an optical sensor in the display area; a data line extending from the chip area to the display area in the second direction and electrically connecting the pixel to the driving chip; a readout line extending from the pad area to the display area in the second direction and electrically connected to the optical sensor; a power line extending from the pad area in the second direction and overlapping the readout line in the non-display area; and an inorganic encapsulation layer on the third organic layer to cover the light emitting element and in contact with the contact area of the sixth inorganic layer within the sealing area. In one or more embodiments, the data line and the readout line do not overlap each other in the non-display area, the readout line and the power line may overlap each other in the sealing area, the readout line may be located below the first inorganic layer within the sealing area or located between the fifth inorganic layer and the sixth inorganic layer, and the power line may be located between the first inorganic layer and the fourth inorganic layer.

According to an aspect, there is provided a display device comprising: a base layer comprising a display area, which comprises a first area and a second area adjacent to the first area in a first direction, and a non-display area, which comprises a chip area and a pad area disposed farther from the display area than the chip area in a second direction crossing the first direction; a driving chip disposed on the chip area; a first pixel disposed on the first area and comprising a first light emitting element; a first optical sensor disposed on the second area; a first data line extending from the chip area to the first area and electrically connecting the first pixel to the driving chip; a first readout line extending from the pad area to the second area and electrically connected to the first optical sensor; and a power line extending from the pad area to overlap the first readout line within the non-display area, wherein the first data line and the first readout line do not overlap each other within the non-display area, and the first readout line and the power line are disposed on different layers within an area of the non-display area on which the first readout line and the power line overlap each other.

In some embodiments, the display device further comprises a plurality of inorganic layers disposed on the base layer to overlap the display area and the non-display area; a plurality of organic layers disposed on the plurality of inorganic layers and exposing a contact area of the uppermost inorganic layer of the plurality of inorganic layers within the non-display area; and a thin film encapsulation layer disposed on the plurality of organic layers to cover the first light emitting element and in contact with the contact area of the uppermost inorganic layer.

In some embodiments, the non-display area further comprises a sealing area corresponding to the contact area of the uppermost inorganic layer, and the first readout line and the power line overlap each other within the sealing area.

In some embodiments, the first readout line and the power line are disposed below the uppermost inorganic layer within the sealing area.

In some embodiments, the first data line and the power line are disposed on the same layer within the sealing area.

In some embodiments, the sealing area is disposed between the display area and the chip area in the second direction.

In some embodiments, the pixel further comprises a shielding electrode, a dummy electrode, a first transistor, and a second transistor, wherein the first transistor comprises a silicon semiconductor layer and a first gate electrode disposed on the silicon semiconductor layer, a second transistor comprises an oxide semiconductor layer disposed on the first gate electrode and a second gate electrode disposed on the oxide semiconductor layer, the dummy electrode is disposed between the first gate electrode and the second gate electrode, and the shielding electrode is disposed below the silicon semiconductor layer.

In some embodiments, the first readout line comprises a first portion disposed on the same layer as the shielding electrode within the sealing area, and the power line comprises a first portion disposed on the same layer as the first gate electrode or the dummy electrode within the sealing area.

In some embodiments, the non-display area further comprises a bending area disposed between the sealing area and the pad area, the first readout line further comprises a second portion disposed on a different layer from the first portion of the first readout line within the bending area, and the power line further comprises a second portion disposed on a different layer from the first portion of the power line within the bending area.

In some embodiments, the first readout line comprises a first portion disposed on the same layer as the shielding electrode within the sealing area, and the power line comprises a first portion disposed on the same layer as the first gate electrode and a second portion disposed on the same layer as the dummy electrode within the sealing area, and wherein the first portion and the second portion are electrically connected to each other a contact hole through which an inorganic layer disposed between the first portion and the second portion passes among the plurality of inorganic layers.

In some embodiments, the first readout line comprises a first portion disposed on the same layer as the shielding electrode within the sealing area, and the power line comprises a first portion disposed on the same layer as the second gate electrode within the sealing area.

In some embodiments, the non-display area further comprises a bending area that is bent so that a portion of the base layer corresponding to the display area and a portion of the base layer corresponding to the pad area become close to each other, and the first data line, the first readout line, and the power line are disposed on the same layer within the bending area.

In some embodiments, the first readout line and the power line are disposed on different layers within an area between the bending area and the pad area of the non-display area in the second direction.

In some embodiments, the non-display area corresponding to the bending area has a width less than that of the non-display area corresponding to the pad area in the first direction.

In some embodiments, display device further comprises a second pixel disposed on the second area and comprising a second light emitting element; a dummy data line extending from the chip area to the first area; a second data line disposed on the second area and electrically connected to the second light emitting element; and a connection line electrically connecting the second data line to the dummy data line.

In some embodiments, the display device further comprises a second optical sensor disposed on the first area; a dummy readout line extending from the pad area to the second area; a second readout line disposed on the first area electrically connected to the second optical sensor; and a connection line electrically connecting the second readout line to the dummy readout line.

According to an aspect, there is provided a display device comprising: a base layer comprising a display area which are defined in first and second directions crossing each other, a sealing area, a pad area disposed farther from the display area than the sealing area in the second direction, and a chip area disposed between the sealing area and the pad area; first to sixth inorganic layers disposed on the base layer, overlapping the display area and the non-display area, and sequentially laminated; first to third organic layers disposed on the sixth inorganic layer, exposing a contact area of the sixth inorganic layer within the sealing area, and sequentially laminated; a driving chip disposed on the chip area; a pixel disposed on the display area and comprising a shielding electrode, a dummy electrode, a first transistor, a second transistor, and a light emitting element; an optical sensor disposed on the display area; a data line extending from the chip area to the display area and electrically connecting the pixel to the driving chip; a readout line extending from the pad area to the display area and electrically connected to the optical sensor; a power line extending from the pad area and overlapping the readout line within the non-display area; and an inorganic encapsulation layer disposed on the third organic layer to cover the light emitting element and in contact with the contact area of the sixth inorganic layer within the sealing area, wherein the data line and the readout line do not overlap each other within the non-display area, the readout line and the power line overlap each other within the sealing area, the readout line is disposed below the first inorganic layer within the sealing area or disposed between the fifth inorganic layer and the sixth inorganic layer, and the power line is disposed between the first inorganic layer and the fourth inorganic layer.

In some embodiments, the first transistor comprises a silicon semiconductor layer disposed below the first inorganic layer and a first gate electrode disposed between the first inorganic layer and the second inorganic layer, the second transistor comprises an oxide semiconductor layer disposed between the third inorganic layer and the fourth inorganic layer and a second gate electrode disposed between the fourth inorganic layer and the fifth inorganic layer, the dummy electrode is disposed between the second inorganic layer and the third inorganic layer, and the shielding electrode is disposed below the first inorganic layer.

In some embodiments, the first readout line comprises a first portion disposed below the first inorganic layer within the sealing area, and the power line comprises a first portion disposed on the same layer as the first gate electrode and a second portion disposed on the same layer as the dummy electrode within the sealing area, wherein the first portion and the second portion are connected to each other a contact hole through which the second inorganic layer passes.

In some embodiments, the first readout line comprises a first portion disposed on the same layer as the second gate electrode within the sealing area, and the power line comprises a first portion disposed on the same layer as the first gate electrode and a second portion disposed on the same layer as the dummy electrode within the sealing area, wherein the first portion and the second portion are connected to each other a contact hole through which the second inorganic layer passes.

According to an aspect, there is provided a display device as set out in claim 1. Additional features are set out in claims 2 to 15.

### BRIEF DESCRIPTION OF THE FIGURES

The accompanying drawings are included to provide a further understanding of the present disclosure, and are incorporated in and constitute a part of the present disclosure. The drawings illustrate embodiments of the present disclosure and, together with the description, serve to explain principles of embodiments of the present disclosure. In the drawings:
FIG. 1 is a perspective view of a display device according to one or more embodiments of the present disclosure;
FIG. 2 is a cross-sectional view illustrating an example of the display device illustrated in FIG. 1;
FIG. 3 is a cross-sectional view illustrating an example of a display panel illustrated in FIG. 2;
FIG. 4 is a block diagram of the display device according to one or more embodiments of the present disclosure;
FIG. 5 is illustrating an equivalent circuit of one pixel of pixels illustrated in FIG. 4 and an optical sensor adjacent to the pixel;
FIG. 6 is a cross-sectional view illustrating an example of a light emitting element, a first transistor, a fourth transistor, and a sixth transistor of the pixel illustrated in FIG. 5;
FIG. 7 is a cross-sectional view illustrating an example of an optical sensing element, a first sensing transistor, and a second sensing transistor of an optical sensor illustrated in FIG. 5.
FIG. 8 is a view illustrating a planar arrangement of light emitting elements and optical sensing elements, which are arranged on a partial area of the display area illustrated in FIG. 4;
FIG. 9 is a plan view of a display device according to one or more embodiments of the present disclosure;
FIG. 10 is a plan view illustrating a partial area of the display device according to one or more embodiments of the present disclosure;
FIG. 11 is a plan view illustrating a partial area of the display device according to one or more embodiments of the present disclosure;
FIG. 12 is a plan view illustrating a data line, a readout line, and a power line according to one or more embodiments of the present disclosure;
FIG. 13 is a cross-sectional view taken along the line I-I' of FIG. 12; and
FIGs. 14 - 16 are cross-sectional views illustrating a sealing portion of the display device according to one or more embodiments of the present disclosure.

### DETAILED DESCRIPTION

In the present disclosure, it will also be understood that if (e.g., when) one component (or area, layer, portion) is referred to as being 'arranged on', 'connected to', or 'coupled to' another component, it can be directly arranged/connected/coupled on/to the one component, or an intervening third component may also be present.

Like reference numerals refer to like elements throughout, and duplicative descriptions thereof may not be provided. Also, in the drawings, the thickness, ratio, and dimensions of components are exaggerated for clarity of illustration. The term "and/or" includes any and all combinations of one or more of the associated elements.

It will be understood that although the terms such as 'first' and 'second' are used herein to describe one or more suitable elements, these elements should not be limited by these terms. These terms are used only to distinguish one component from other components. For example, a first element referred to as a first element in one or more embodiments may be referred to as a second element in one or more embodiments without departing from the scope of the present disclosure. The terms of a singular form may include plural forms unless referred to the contrary.

Also, "under", "below", "on', "above", and/or the like are used for explaining relation association of the elements illustrated in the drawings. The terms may be a relative concept and described based on directions expressed in the drawings.

The meaning of 'include' or 'include' specifies a property, a fixed number, a process, an operation, an element, a component and/or a (e.g., any suitable) combination thereof, but does not exclude other properties, fixed numbers, processes, operations, elements, components and/or one or more (e.g., any suitable) combinations thereof.

Unless otherwise defined, all terms (including technical and scientific terms) used herein have the same meaning as commonly understood by a person of ordinary skill in the art to which the present disclosure belongs. In addition, terms such as terms defined in commonly used dictionaries should be interpreted as having a meaning consistent with the meaning in the context of the related technology, and unless explicitly defined here, they are interpreted as too ideal or too formal sense.

Hereinafter, embodiments of the present disclosure will be described with reference to the accompanying drawings.

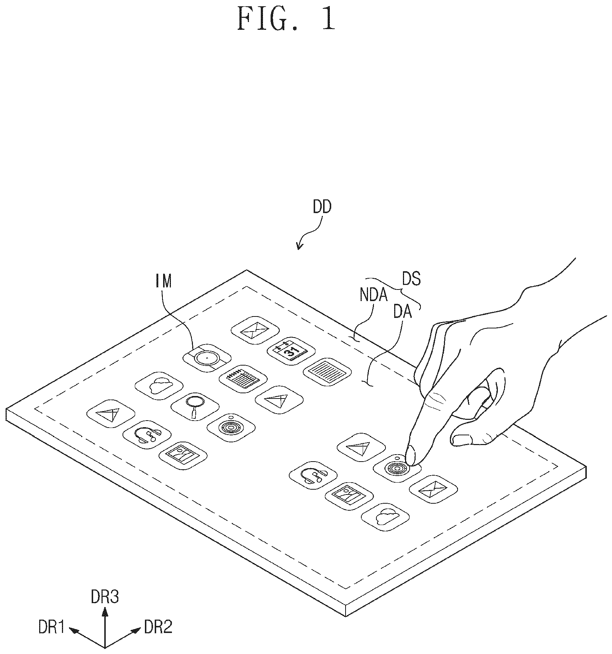

FIG. 1 is a perspective view of a display device DD according to one or more embodiments of the present disclosure.

Referring to FIG. 1, the display device DD according to one or more embodiments of the present disclosure may have a rectangular shape having long sides extending in a first direction DR1 and short sides extending in a second direction DR2 crossing the first direction DR1. However, embodiments of the present disclosure are not necessarily limited thereto. For example, the display device DD may have one or more suitable shapes such as a circular shape or a polygonal shape. Hereinafter, a direction that substantially normally (e.g., perpendicularly) crosses a plane defined by the first direction DR1 and the second direction DR2 is defined as a third direction DR3. In the present disclosure, the meaning if (e.g., when) viewed on a "plane" is defined as a state viewed in the third direction D3.

A top surface of the display device DD may be defined as a display surface DS and have a plane defined by the first direction DR1 and the second direction DR2. Images IM generated in the display device DD may be provided to a user through the display surface DS.

The display surface DS may include a display area DA and a non-display area NDA around the display area DA along an edge or a periphery of the display area DA. The display area DA may display an image, and the non-display area NDA might not display an image. The non-display area NDA may be around (e.g., surround) the display area DA, but embodiments of the present disclosure are not necessarily limited thereto, and the non-display area NDA may be arranged at one side of the display area DA.

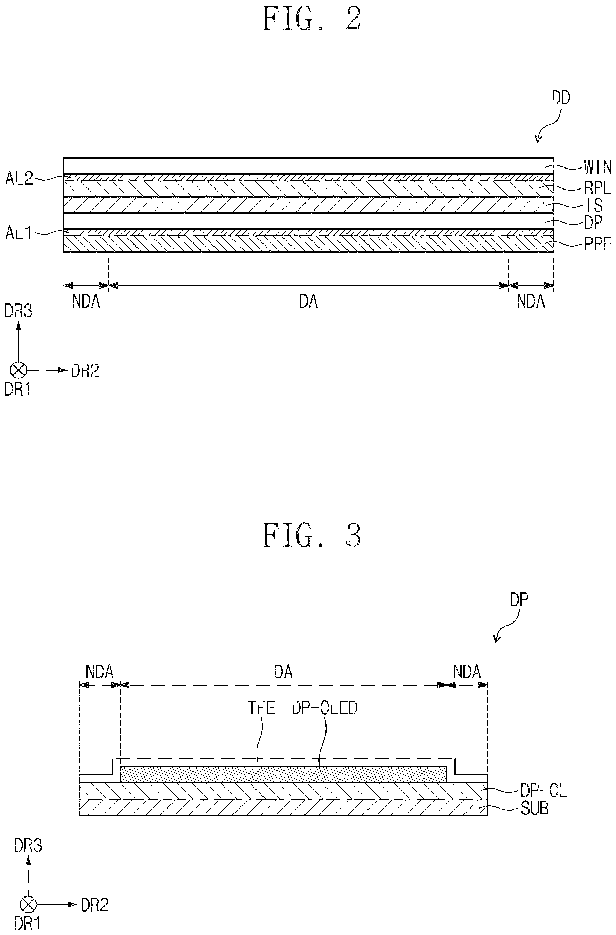

FIG. 2 is a cross-sectional view illustrating an example of the display device DD illustrated in FIG. 1.

Referring to FIG. 2, the display device DD includes a display panel DP, an input sensor IS, an anti-reflection layer RPL, a window WIN, a panel protection film PPF, and first and second adhesive layers AL1 and AL2. In one or more embodiments of the present disclosure, the input sensor IS may not be provided.

The display panel DP according to one or more embodiments of the present disclosure may be an emission-type or kind display panel, but is not particularly limited thereto. For example, the display panel DP may be an organic light emitting display panel or an inorganic light emitting display panel. An emission layer of the organic light emitting display panel may include an organic light emitting material. An emission layer of the inorganic light emitting display panel may include a quantum dot, a quantum rod, and/or the like. Hereinafter, the display panel DP will be described as the organic light emitting display panel.

The input sensor IS may be arranged on the display panel DP. The input sensor IS may include a plurality of sensors that sense an external input in a capacitive manner. The input sensor IS may be arranged directly on the display panel DP if (e.g., when) manufacturing the display device DD. However, embodiments of the present disclosure are not necessarily limited thereto, and the input sensor IS may be provided as a panel that is separated from the display panel DP and then may be attached to the display panel DP by an adhesion layer.

The anti-reflection layer RPL may be arranged on the input sensor IS. The anti-reflection layer RPL may be arranged directly on the input sensor IS if (e.g., when) manufacturing the display device DD. The anti-reflection layer RPL may include a color filter and may further include a black mattress.

However, embodiments of the present disclosure are not necessarily limited thereto, and the anti-reflection layer RPL may be provided as a separate panel and then attached to the input sensor IS through the adhesive layer. The anti-reflection layer RPL may include an optical film such as a polarizing film. The anti-reflection layer RPL may reduce reflectance of external light incident toward the display panel DP from an upper side of the display device DD. The external light might not be visible to the user due to the anti-reflection layer RPL.

The window WIN may be arranged on the anti-reflection layer RPL. The window WIN may protect the display panel DP, the input sensor IS, and the anti-reflection layer RPL against external scratches and impacts. The window WIN may be attached to the anti-reflection layer RPL by the second adhesive layer AL2.

The panel protection film PPF may be arranged below the display panel DP. The panel protection film PPF may protect a lower portion of the display panel DP. The panel protection film PPF may include a flexible plastic material such as polyethylene terephthalate (PET). The panel protection film PPF may be attached to the display panel DP by the first adhesive layer AL1.

FIG. 3 is a cross-sectional view illustrating an example of the display panel illustrated in FIG. 2.

Referring to FIG. 3, the display panel DP may include a base layer SUB, a circuit element layer DP-CL arranged on the base layer SUB, a display element layer DP-OLED arranged on the circuit element layer DP-CL, and a thin film encapsulation layer TFE arranged on the display element layer DP-OLED.

The base layer SUB may include a display area DA and a non-display area NDA around the display area DA, like the display device DD of FIG. 1. The base layer SUB may include flexible plastic material and/or glass such as polyimide.

The circuit element layer DP-CL may include a driving circuit of the light emitting element and a driving circuit of the optical sensing element. The display device layer DP-OLED may include the light emitting element and the optical sensing element. The thin film encapsulation layer TFE may be arranged on the circuit element layer DP-CL to cover the display element layer DP-OLED. The thin film encapsulation layer TFE may protect the pixels from moisture, oxygen, and/or external foreign substances.

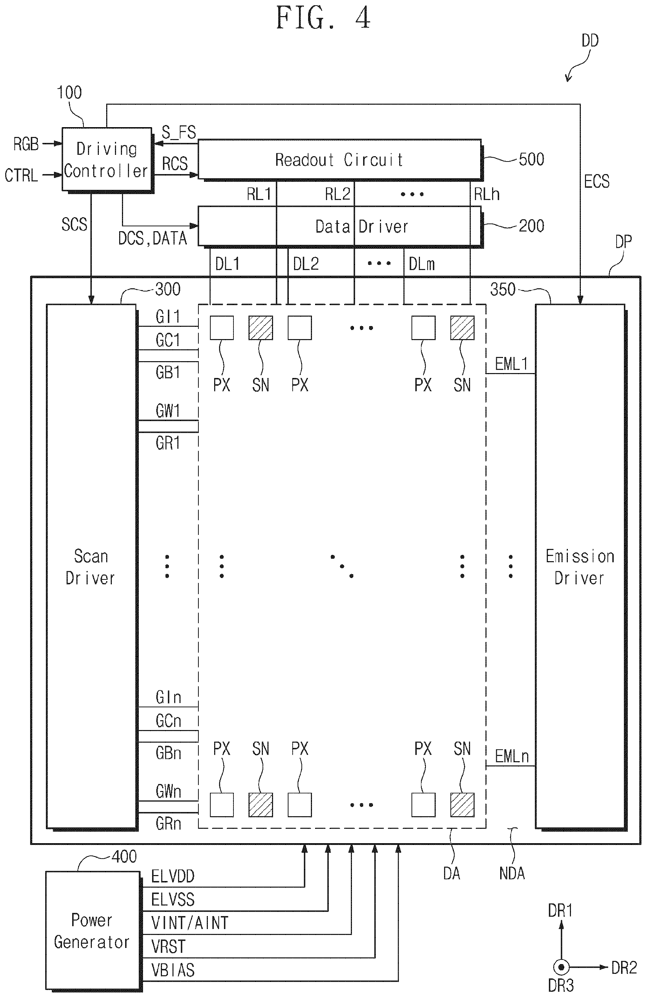

FIG. 4 is a block diagram of the display device according to one or more embodiments of the present disclosure.

Referring to FIG. 4, the display device DD includes a display panel DP, a driving controller 100, and a driving circuit of the display device. For example, the driving circuit of the display device may include a data driver 200, a scan driver 300, an emission driver 350, a voltage generator 400, and a readout circuit 500. In one or more embodiments, the voltage generator 400 and the readout circuit 500 may be implemented as a single driving chip with the driving controller 100.

The display panel DP may include a plurality of pixels PX arranged on the display area DA and a plurality of optical sensors SN arranged on the display area DA. For example, each of the optical sensors SN may be arranged between two adjacent pixels PX. However, the arrangement relationship between the optical sensors SN and the pixels PX is not necessarily limited thereto.

The display panel DP may include initialization scan lines GI1 to GIn, compensation scan lines GC1 to GCn, bias scan lines GB1 to GBn, write scan lines GW1 to GWn, emission control lines EML1 to EMLn, reset scan lines GR1 to GRn, data lines DL1 to DLm, and readout lines RL1 to RLh. The initialization scan lines GI1 to GIn, the compensation scan lines GC1 to GCn, the bias scan lines GB1 to GBn, the write scan lines GW1 to GWn, the emission control lines EML1 to EMLn, and the reset scan lines GR1 to GRn may extend in the second direction DR2. The data lines DL1 to DLm and the readout lines RL1 to RLh may extend in the first direction DR1.

The pixels PX may be electrically connected to the initialization scan lines GI1 to GIn, the compensation scan lines GC1 to GCn, the write scan lines GW1 to GWn, the bias scan lines GB1 to GBn, the emission control lines EML1 to EMLn, and the data lines DL1 to DLm. However, the number of signal lines connected to each pixel PX is not necessarily limited thereto and may vary.

The optical sensors SN may be electrically connected to the write scan lines GW1 to GWn, the reset scan lines GR1 to GRn, and the readout lines RL1 to RLh. The number of signal lines connected to each of the optical sensors SN is not necessarily limited thereto and may vary.

The driving controller 100 may receive an image signal RGB and a control signal CTRL. The driving controller 100 may generate an image data signal DATA that is obtained by converting data format of the image data RGB to meet interface specifications with the data driver 200. The drive controller 100 may output a first control signal DCS, a second control signal SCS, a third control signal ECS, and a fourth control signal RCS.

The data driver 200 may receive the first control signal DCS and the image data signal DATA from the driving controller 100. The data driver 200 may convert the image data signal DATA into data signals and output the data signals to the plurality of data lines DL1 to DLm, which will be described in more detail later. The data signals are analog voltages corresponding to grayscale (e.g., gray level values or gray values) of the image data signal DATA.

The scan driver 300 may receive the second control signal SCS from the drive controller 100. The scan driver 300 may output initialization scan signals to the initialization scan lines GI1 to GIn and output compensation scan signals to the compensation scan lines GC1 to GCn in response to the second control signal SCS. In addition, the scan driver 300 may output write scan signals to the write scan lines GW1 to GWn and output black scan signals to the bias scan lines GB1 to GBn in response to the second control signal SCS. In addition, the scan driver 300 may output reset scan signals to the reset scan lines GR1 to GRn in response to the second control signal SCS.

The emission driver 350 may receive the third control signal ECS from the driving controller 100. The emission driver 350 may output emission control signals to the emission control lines EML1 to EMLn in response to the second control signal ECS. In addition, the scan driver 300 may be connected to the emission control lines EML1 to EMLn. In this case, the emission driver 350 may not be provided, and the scan driver 300 may output emission control signals to the emission control lines EML1 to EMLn.

The readout circuit 500 may receive the fourth control signal RCS from the drive controller 100. The readout circuit 500 may receive sensing signals from the readout lines RL1 to RLh in response to the fourth control signal RCS. The readout circuit 500 may process the sensing signals received from the readout lines RL1 to RLh to provide the processed sensing signals S_FS to the drive controller 100. The drive controller 100 may recognize biometric information based on the sensing signals S_FS.

The voltage generator 400 may generate voltages that are necessary for an operation of the display panel DP. In this embodiment, the voltage generator 400 may generate a first driving voltage ELVDD, a second driving voltage ELVSS having a level lower than that of the first driving voltage ELVDD, a first initialization voltage VINT, a second initialization voltage AINT, a reset voltage VRST, and a bias voltage VBIAS.

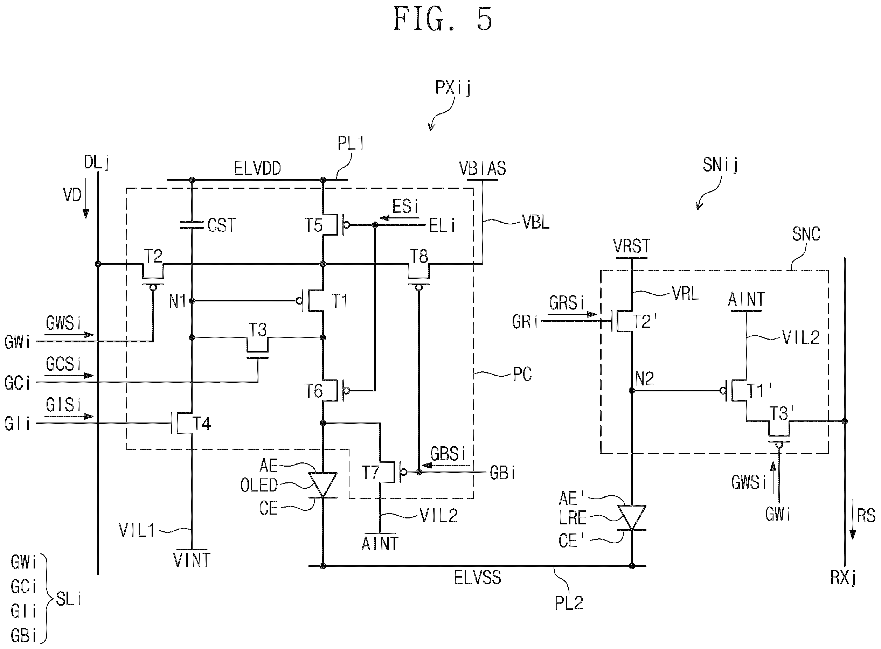

FIG. 5 illustrates an equivalent circuit of one pixel PXij of the pixels PX illustrated in FIG. 4 and an optical sensor SNij that is adjacent to the one pixel PXij.

For example, FIG. 5 illustrates the pixel PXij connected to an i-th scan line SLi, an i-th emission line ELi, and an j-th data line DLj. In addition, FIG. 5 illustrates an optical sensor SNij connected to the i-th reset scan line GRi and the j-th readout line RXj. Here, i and j are natural numbers. The i-th scan lines SLi may include an i-th initialization scan line Gli, an i-th compensation scan line GCi, an i-th bias scan line GBi, and an i-th write scan line GWi.

Referring to FIG. 5, the pixel PXij may include a pixel driving circuit PC (or first driving circuit) and a light emitting element OLED electrically connected to the pixel driving circuit PC. The light emitting element OLED may be turned on or off by the control of the pixel driving circuit PC.

The pixel driving circuit PC may include a plurality of transistors T1 to T8 and a capacitor CST. The transistors T1 to T8 and the capacitor CST may control an amount of current flowing through the light emitting element OLED. The light emitting element OLED may generate light having certain brightness depending on the amount of provided current.

The i-th write scan line GWi may receive an i-th write scan signal GWSi, and the i-th compensation scan line GCi may receive an i-th compensation scan signal GCSi. The i-th initialization scan line Gli may receive an i-th initialization scan signal (GISi), and the i-th bias scan line GBi may receive an i-th bias scan signal GBSi. The i-th reset scan line GRi may receive an i-th reset scan signal GRSi. The i-th emission line ELi may receive an i-th emission signal ESi.

The first initialization line VIL1 may receive the first initialization voltage VINT, and the second initialization line VIL2 may receive the second initialization voltage AINT. The bias line VBL may receive the bias voltage VBIAS. The first power line PL1 may receive the first driving voltage ELVDD, and the second power line PL2 may receive the second driving voltage ELVSS. The light emitting element OLED may be connected to the second power line PL2. The reset line VRL may receive the reset voltage VRST.

Each of the transistors T1 to T8 may include a source (or source terminal), a drain (or drain terminal), and a gate (or gate terminal). Hereinafter, in FIG. 5, for convenience, one of the source and drain is defined as the first electrode, and the other is defined as the second electrode. In addition, the gate is defined as a gate electrode or control electrode.

The transistors T1 to T8 may include first to eighth transistors T1 to T8. The first, second, and fifth to eighth transistors T1, T2, T5 to T8 may be PMOS transistors. The third and fourth transistors T3 and T4 may be NMOS transistors.

The first transistor T1 may be defined as a driving transistor, and the second transistor T2 may be defined as a switching transistor. The third transistor T3 may be defined as a compensation transistor. The fourth transistor T4 and the seventh transistor T7 may be defined as initialization transistors. The fifth transistor T5 and sixth transistor T6 may be defined as emission control transistors. The eighth transistor T8 may be defined as a bias transistor.

The light emitting element OLED may include an organic light emitting diode. The light emitting element OLED may include a first electrode, a second electrode, and an emission layer arranged between the first electrode and the second electrode. In this embodiment, for convenience of explanation, the first electrode is described as an anode AE, and the second electrode is described as a cathode CE. The anode AE may be electrically connected to the first power line PL1 through the sixth, first, and fifth transistors T6, T1, and T5. The cathode CE may be electrically connected to the second power line PL2.

The first transistor T1 may be arranged between the fifth transistor T5 and the sixth transistor T6 and connected to the fifth transistor T5 and the sixth transistor T6. The first transistor T1 may be connected to the first power line PL1 through the fifth transistor T5 and to the anode AE through the sixth transistor T6.

The first transistor T1 may include a first electrode connected to the first power line PL1 through the fifth transistor T5, a second electrode connected to the anode AE through the sixth transistor T6, and a gate electrode of the first transistor T1 may be connected to the first node N1.

The first electrode of the first transistor T1 may be connected to the fifth transistor T5, and the second electrode of the first transistor T1 may be connected to the sixth transistor T6. The first transistor T1 may control an amount of current flowing through the light emitting element OLED according to a voltage of the first node N1, which is applied to the gate electrode of the first transistor T1.

The second transistor T2 may be arranged between the first transistor T1 and the j-th data line DLj and then be connected to the first transistor T1 and the j-th data line DLj. The second transistor T2 may include a first electrode connected to the j-th data line DLj, a second electrode connected to the first electrode of the first transistor T1, and a gate electrode connected to the i-th write scan line GWi.

The second transistor T2 may be turned on by the i-th write scan signal GWSi applied through the i-th write scan line GWi to electrically connect the j-th data line DLj to the first electrode of the first transistor T1. The second transistor T2 may perform a switching operation to provide the data voltage VD applied through the j-th data line DLj to the first electrode of the first transistor T1.

The third transistor T3 may be connected to the second electrode of the first transistor T1 and the first node N1. The third transistor T3 may include a first electrode connected to the second electrode of the first transistor T1, a second electrode connected to the first node N1, and a gate electrode connected to the i-th compensation scan line GCi.

The third transistor T3 may be turned on by the i-th compensation scan signal GCSi applied through the i-th compensation scan line GCi to electrically connect the second electrode of the first transistor T1 to the gate electrode of the first transistor T1. When the third transistor T3 is turned on, the first transistor T1 and the third transistor T3 may be connected in the form of a diode (e.g., the first transistor may be diode-connected).

The fourth transistor T4 may be connected to the first node N1. The fourth transistor T4 may include a first electrode connected to the first node N1, a second electrode connected to the first initialization line VIL1, and a gate electrode connected to the i-th initialization scan line Gli. The fourth transistor T4 may be turned on by the i-th initialization scan signal GISi applied through the i-th initialization scan line Gli to provide the first initialization voltage VINT applied through the first initialization line VIL1 to the first node N1.

The fifth transistor T5 may include a first electrode connected to the first power line PL1, a second electrode connected to the first electrode of the first transistor T1, and a gate electrode connected to the i-th emission line ELi. The sixth transistor T6 may include a first electrode connected to the second electrode of the first transistor T1, a second electrode connected to the anode AE, and a gate electrode connected to the i-th emission line ELi.

The fifth transistor T5 and the sixth transistor T6 may be turned on by the i-th emission signal ESi applied through the i-th emission line ELi. The first driving voltage ELVDD may be provided to the light emitting element OLED by the fifth transistor T5, the first transistor T1, and the sixth transistor T6, which are turned on, so that driving current flows to the light emitting element OLED. Thus, the light emitting element OLED may be to emit light.

The seventh transistor T7 may include a first electrode connected to the anode AE, a second electrode connected to the second initialization line VIL2, and a gate electrode connected to the i-th bias scan line GBi. The seventh transistor T7 may be turned on by the i-th bias scan signal GBSi applied through the i-th bias scan line GBi to provide the second initialization voltage AINT received through the second initialization line VIL2 to the anode AE of the light emitting element OLED.

In one or more embodiments, the seventh transistor T7 may not be provided. In one or more embodiments, the second initialization voltage AINT may have a different level from the first initialization voltage VINT, but embodiments of the present disclosure are not necessarily limited thereto, and may have the same level as the first initialization voltage VINT.

The seventh transistor T7 may improve black display capability of the pixel PXij. When the seventh transistor T7 is turned on, a parasitic capacitor of the light emitting element OLED may be discharged. Thus, if (e.g., when) implementing black luminance, the light emitting element OLED might not emit light due to the leakage current of the first transistor T1, and thus, the block display capability may be improved.

The capacitor CST may include a first electrode connected to the first power line PL1 and a second electrode connected to the first node N1. When the fifth transistor T5 and the sixth transistor T6 are turned on, an amount of current flowing through the first transistor T1 may be determined according to the voltage stored in the capacitor CST.

The eighth transistor T8 may include a first electrode connected to the bias line VBL, a second electrode connected to the first electrode of the first transistor T1, and a gate electrode connected to the i-th bias scan line GBi. In one or more embodiments, the third transistor T8 may not be provided.

The eighth transistor T8 may be turned on by the i-th bias scan signal GBSi and may provide the bias voltage VBIAS to the first electrode of the first transistor T1. As the bias voltage VBIAS is applied to the first transistor T1, movement of a hysteresis curve of the first transistor T1 may be suppressed or reduced.

The optical sensor SNij may include a sensor driving circuit SNC (or a second driving circuit) and an optical sensing element LRE electrically connected to the sensor driving circuit SNC. The sensor driving circuit SNC may detect an operation of the optical sensing element LRE.

The sensor driving circuit SNC may include a first sensing transistor T1', a second sensing transistor T2', and a third sensing transistor T3'. The first and third transistors T1' and T3' may be PMOS transistors, and the second sensing transistor T2' may be an NMOS transistor.

The optical sensing element LRE may be defined as a photodiode. The optical sensing element LRE may convert light energy incident from the outside into electrical energy. The optical sensing element LRE may include a first electrode, a second electrode, and a photoelectric conversion layer arranged between the first electrode and the second electrode. In this embodiment, for convenience of explanation, the first electrode is described as an anode AE', and the second electrode is described as a cathode CE'. The anode AE' may be connected to a second node N2, and the cathode CE' may be connected to the second power line PL2. To distinguish the anode AE and the cathode CE of the light emitting element OLED from the anode AE' and the cathode CE' of the optical sensing element LRE, the anode AE and the cathode CE may be defined as the first and second electrodes, respectively, and the anode AE' and the cathode CE' of the optical sensing element LRE may be defined as a first-1 electrode and a second-1 electrode, respectively.

The first sensing transistor T1' may be connected to the optical sensing element LRE, the second sensing transistor T2', and the third sensing transistor T3'. The first sensing transistor T1' may include a first electrode receiving the second initialization voltage AINT, a gate electrode connected to the second node N2, and a second electrode connected to the third sensing transistor T3'. The first electrode of the first sensing transistor T1' may be connected to the second initialization line VIL2 to receive the second initialization voltage AINT. The second sensing transistor T2' may include a first electrode connected to the second node N2, a gate electrode connected to the i-th reset scan line GRi, and a second electrode connected to the reset line VRL. The third sensing transistor T3' may include a first electrode connected to the second electrode of the first sensing transistor T1', a gate electrode connected to the i-th write scan line GWi, and a second electrode connected to the readout line RXj. The third sensing transistor T3' may be turned on by the i-th write scan signal GWSi received through the i-th write scan line GWi.

The second sensing transistor T2' may be turned on by the i-th reset scan signal GRSi received through the i-th reset scan line GRi. The second sensing transistor T2' that is turned on may receive the reset voltage VRST to provide the reset voltage VRST to the second node N2. The second node N2 may be reset by the reset voltage VRST. In one or more embodiments, all the optical sensors SN illustrated in FIG. 4 may receive the same reset scan signal. The second sensing transistor T2' of all the optical sensors SN may be turned on at the same timing and also turned off at the same timing.

The i-th write scan signal GWSi may be applied to the gate electrode of the third sensing transistor T3' to turn on the third sensing transistor T3'. The first sensing transistor T1' may be connected to the readout line RXj by the third sensing transistor T3' that is turned on.

The optical sensing element LRE may receive light to convert the light into an electrical signal. Here, the voltage of the second node N2 may be changed. When the first sensing transistor T1' is turned on, the second initialization voltage AINT provided to the first sensing transistor T1' may be controlled or selected according to the change in voltage of the second node N2 and then be provided to the readout line RXj through the third sensing transistor T3'. Thus, the signal sensed by the optical sensing element LRE may be output as the sensing signal RS through the readout line RXj.

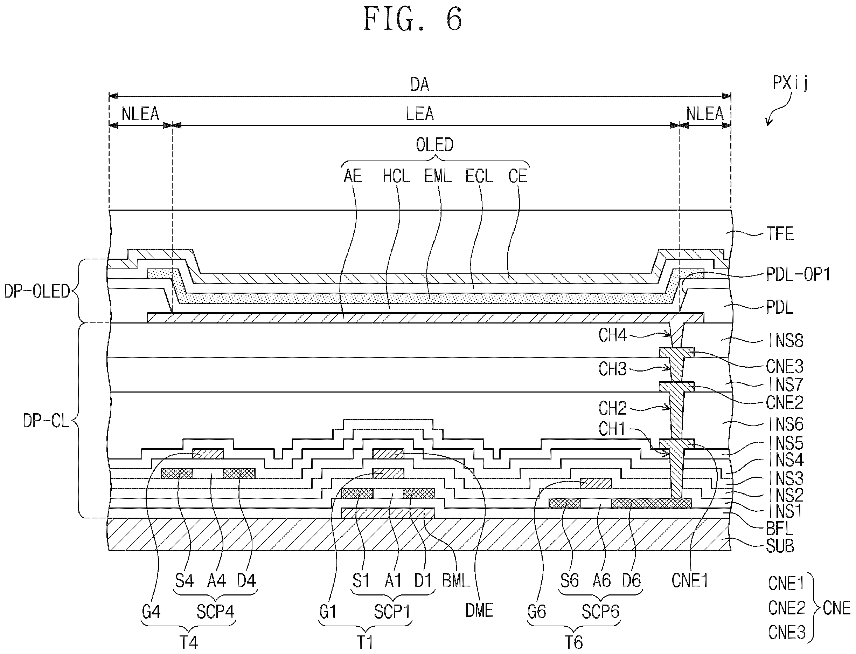

FIG. 6 is a cross-sectional view illustrating an example of the light emitting element OLED, the first transistor T1, the fourth transistor T4, and the sixth transistor T6 of the pixel PXij illustrated in FIG. 5.

FIG. 6 illustrates the first, fourth, and sixth transistors T1, T4, and T6 of the pixel driving circuit PC of FIG. 5. Referring to FIG. 6, a shielding electrode BML may be arranged on the base layer SUB. The shielding electrode BML may overlap the first transistor T1 in a thickness direction of the base layer SUB (e.g., the third direction DR3). The shielding electrode BML may include a metal, and a constant voltage may be applied to the shielding electrode BML. When the constant voltage is applied to the shielding electrode BML, a value of a threshold voltage Vth of the first transistor T1 arranged on the shielding electrode BML may be maintained without being changed. In addition, the shielding electrode BML may block light incident on the first transistor T1 from a lower side of the shielding electrode BML. For example, the shielding electrode BML may include a reflective metal. In one or more embodiments, the shielding electrode BML may not be provided.

A buffer layer BFL may be arranged on the base layer SUB, and the buffer layer BFL may include an inorganic layer. The buffer layer BFL may cover the shielding electrode BML. A metal layer arranged on the base layer SUB together with the shielding electrode BML may be defined as a shielding layer. In one or more embodiments, the buffer layer BFL may not be provided.

A semiconductor layer SCP1 (or semiconductor pattern region, hereinafter, referred to as a first semiconductor layer) of the first transistor T1 and a semiconductor layer SCP6 (or semiconductor pattern region, hereinafter, referred to as a sixth semiconductor layer) of the sixth transistor T6 may be arranged on the buffer layer BFL. Hereinafter, each of the first and sixth semiconductor layers SCP1 and SCP6 may include polysilicon. However, embodiments of the present disclosure are not necessarily limited thereto, and each of the first and sixth semiconductor layers SCP1 and SCP6 may include amorphous silicon.

The first and sixth semiconductor layers SCP1 and SCP6 may be formed through substantially the same process, and a partial region of each of the first and sixth semiconductor layers SCP1 and SCP6 may be doped with an N-type or kind dopant or a P-type or kind dopant. Each of the first and sixth semiconductor layers SCP1 and SCP6 may include a high-doped region and a low-doped region. The high-doped region has conductivity greater than that of the low-doped region. The high-doped regions may substantially correspond to the source and drain of the first and sixth transistors T1 and T6. The low-doped region may substantially correspond to the active (or channel) of the first and sixth transistors T1 and T6.

The high-doped region of the first semiconductor layer SCP1 may include a first source region S1 and a first drain region D1. The low-doped region of the first semiconductor layer SCP1 may be defined as a first channel region A1 and may be arranged between the first source region S1 and the first drain region D1. The sixth semiconductor layer SCP6 may include a sixth source region S6, a sixth channel region A6, and a sixth drain region D6, similar to the first semiconductor layer SCP1.

In the cross-section of FIG. 6, the first semiconductor layer SCP1 and the sixth semiconductor layer SCP6 may be spaced (e.g., spaced apart or separated)from each other, but on a same plane, the first semiconductor layer SCP1 and the sixth semiconductor layer SCP6 may be integrated with each other. For example, the first semiconductor layer SCP1 and the sixth semiconductor layer SCP6 may be different portions or different regions of one semiconductor pattern.

A first insulating layer INS1 covering the first and sixth semiconductor layers SCP1 and SCP6 may be arranged on the buffer layer BFL. The gate electrodes of the first and sixth transistors T1 and T6 may be arranged on the first insulating layer INS1. The gate electrodes of the first and sixth transistors T1 and T6 may be formed through substantially the same process. Hereinafter, the gate electrode of the first transistor T1 may be defined as a first gate electrode G1, and the gate electrode of the sixth transistor T6 may be defined as a sixth gate electrode G6. A metal layer arranged on the first insulating layer INS1 together with the first gate electrode G1 may be defined as a first gate layer. The first gate layer may further include a plurality of patterns in addition to the first gate electrode G1 and the sixth gate electrode G6. The first gate electrode G1 and the sixth gate electrode G6 may respectively overlap the first channel region A1 and the sixth channel region A6 in the third direction DR3

A second insulating layer INS2 may be arranged on the first insulating layer INS1 to cover the first and sixth gate electrodes G1 and G6. A dummy electrode DME may be arranged on the second insulating layer INS2. The dummy electrode DME may be arranged on the first gate electrode G1 to overlap the first gate electrode G1 if (e.g., when) viewed in the plan view (e.g., the dummy electrode DME may overlap the first gate electrode G1 in the third direction DR3). The dummy electrode DME may form the above-described capacitor CST together with the first gate electrode G1. For example, the first gate electrode G1 may correspond to one electrode of the capacitor CST, and the dummy electrode DME may correspond to the other electrode of the capacitor CST. A metal layer arranged on the second insulating layer INS2 together with the dummy electrode DME may be defined as a second gate layer. The second gate layer may further include a plurality of patterns as well as the dummy electrode DME.

A third insulating layer INS3 may be arranged on the second insulating layer INS2 to cover the dummy electrode DME. The semiconductor layer SCP4 (or semiconductor pattern area, hereinafter, referred to as a fourth semiconductor layer) of the fourth transistor T4 may be arranged on the third insulating layer INS3. The fourth semiconductor layer SCP4 may include an oxide semiconductor including metal oxide. The oxide semiconductor may include a crystalline or amorphous oxide semiconductor.

The fourth semiconductor layer SCP4 may include a plurality of regions divided depending on whether the metal oxide is reduced. A region in which the metal oxide is reduced (hereinafter, referred to as a reduction region) has conductivity higher than that of a region in which the metal oxide is not reduced (hereinafter, referred to as a non-reduction region). The reduction regions may substantially correspond to the source and the drain of the fourth transistor T4. The non-reduction region may substantially correspond to the active (or channel) of the fourth transistor T4.

The reduction regions of the fourth semiconductor layer SCP4 may include a fourth source region S4 and a fourth drain region D4. The fourth channel area A4 may be arranged between the fourth source area S4 and the fourth drain area D4.

A fourth insulating layer INS4 may be arranged on the third insulating layer INS3 to cover the fourth semiconductor layer SCP4. The fourth gate electrode G4 of the fourth transistor T4 may be arranged on the fourth insulating layer INS4. A metal layer formed on the fourth insulating layer INS4 together with the fourth gate electrode G4 may be defined as a third gate layer. The third gate layer may further include a plurality of patterns in addition to the fourth gate electrode G4. The fourth gate electrode G4 may overlap the fourth channel area A4 in the third direction DR3.

A fifth insulating layer INS5 may be arranged on the fourth insulating layer INS4 to cover the fourth gate electrode G4. The buffer layer BFL and the first to fifth insulating layers INS1 to INS5 may include inorganic layers.

A connection electrode CNE may be arranged between the sixth transistor T6 and the light emitting element OLED. The connection electrode CNE may electrically connect the sixth transistor T6 to the light emitting element OLED. The connection electrode CNE may include a first connection electrode CNE1, a second connection electrode CNE2 arranged on the first connection electrode CNE1, and a third connection electrode CNE3 arranged on the second connection electrode CNE2.

The first connection electrode CNE1 may be arranged on the fifth insulating layer INS5 and may be connected to the sixth drain region D6 through a first contact hole CH1 defined in the first to fifth insulating layers INS1 to INS5. The metal layer arranged on the fifth insulating layer INS5 together with the first connection electrode CNE1 may be defined as a first source/drain layer. The first source/drain layer may further include a plurality of patterns in addition to the first connection electrode CNE1.

A sixth insulating layer INS6 may be arranged on the fifth insulating layer INS5 to cover the first connection electrode CNE1. The second connection electrode CNE2 may be arranged on the sixth insulating layer INS6. The second connection electrode CNE2 may be connected to the first connection electrode CNE1 through a second contact hole CH2 defined in the sixth insulating layer INS6. The metal layer arranged on the sixth insulating layer INS6 together with the second connection electrode CNE2 may be defined as a second source/drain layer. The second source/drain layer may further include a plurality of patterns in addition to the second connection electrode CNE2.

A seventh insulating layer INS7 may be arranged on the sixth insulating layer INS6 to cover the second connection electrode CNE2. The third connection electrode CNE3 may be arranged on the seventh insulating layer INS7. The third connection electrode CNE3 may be connected to the second connection electrode CNE2 through a third contact hole CH3 defined in the seventh insulating layer INS7. The metal layer arranged on the seventh insulating layer INS7 together with the third connection electrode CNE3 may be defined as a third source/drain layer. The third source/drain layer may further include a plurality of patterns in addition to the third connection electrode CNE3.

An eighth insulating layer INS8 may be arranged on the seventh insulating layer INS7 to cover the third connection electrode CNE3. The light emitting element OLED may be arranged on the eighth insulating layer INS8. Each of the sixth to eighth insulating layers INS6 to INS8 may include an inorganic layer or an organic layer. In this embodiment, each of the sixth to eighth insulating layers INS6 to INS8 may include an organic layer.

The light emitting element OLED may include a first electrode AE, a second electrode CE, a hole control layer HCL, an electron control layer ECL, and an emission layer EML. The first electrode AE may be the anode AE illustrated in FIG. 5, and the second electrode CE may be the cathode CE illustrated in FIG. 5. The second electrode CE may be arranged on the first electrode AE, the hole control layer HCL and the electron control layer ECL may be arranged between the first electrode AE and the second electrode CE, and the emission layer EML may be arranged between the hole control layer HCL and the electronic control layer ECL. The first electrode AE may be arranged on the eighth insulating layer INS8. The first electrode AE may be electrically connected to the third connection electrode CNE3 through a fourth contact hole CH4 defined in the eighth insulating layer INS8.

A pixel defining layer PDL exposing a suitable portion (e.g., a set or predetermined portion) of the first electrode AE may be arranged on the first electrode AE and the eighth insulating layer INS8. A first opening PDL-OP1 through which a suitable portion (e.g., a set or predetermined portion) of the first electrode AE is exposed may be defined in the pixel defining layer PDL. The first opening PDL-OP1 may correspond to an emission area LEA. The display area DA may include the emission area LEA corresponding to the first opening PDL-OP1 and a non-emission area NLEA adjacent to the emission area LEA.

The hole control layer HCL may be arranged on the first electrode AE and the pixel defining layer PDL. The hole control layer HCL may be commonly arranged on the emission area LEA and the non-emission area NLEA. The hole control layer HCL may include a hole transport layer and a hole injection layer.

The emission layer EML may be arranged on the hole control layer HCL. The emission layer EML may be arranged on an area corresponding to the first opening PDL-OP1. The emission layer EML may include an organic material and/or an inorganic material. The emission layer EML may be to emit one of red light, green light, and/or blue light.

The electronic control layer ECL may be arranged on the hole control layer HCL to cover the emission layer EML. The electronic control layer ECL may be commonly arranged on the emission area LEA and the non-emission area NLEA. The electronic control layer ECL may include an electron transport layer and an electron injection layer.

The second electrode CE may be arranged on the electronic control layer ECL. The second electrode CE may be commonly arranged on the pixels PX illustrated in FIG. 4. For example, the second electrode CE may be commonly arranged on the emission layers EML of the pixels PX.

A layer arranged from the buffer layer BFL to the eighth insulating layer INS8 may be defined as the circuit element layer DP-CL. A layer on which the light emitting element OLED is arranged may be defined as the display element layer DP-OLED.

A thin film encapsulation layer TFE may be arranged on the light emitting element OLED. The thin film encapsulation layer TFE may include an inorganic layer, an organic layer, and an inorganic layer, which are sequentially laminated. Each of the inorganic layers may include an inorganic material and protect the pixels against moisture/oxygen. The organic layer may include an organic material to protect the pixels PX against foreign substances such as dust particles.

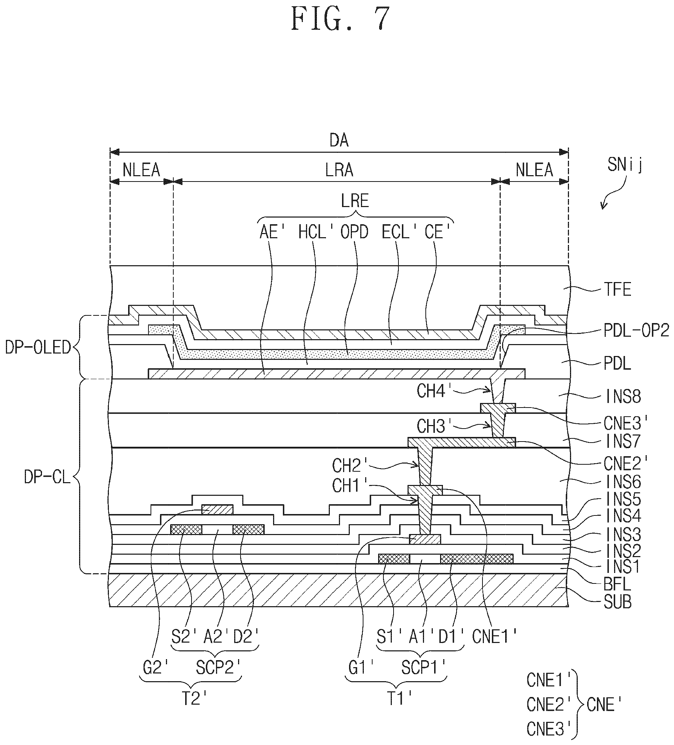

FIG. 7 is a cross-sectional view illustrating an example of the optical sensing element LRE, the first sensing transistor T1', and the second sensing transistor T2' of the optical sensor SNij illustrated in FIG. 5. Hereinafter, detailed descriptions of the same configuration as that described in FIG. 6 will be described with reference to FIG. 6.

The semiconductor layer SCP1' (hereinafter, referred to as a first sensing semiconductor layer) of the first sensing transistor T1' may be formed through substantially the same process as the first semiconductor layer SCP1 of FIG. 6, and the semiconductor layer SCP2' (hereinafter, referred to as a second sensing semiconductor layer) of the second sensing transistor T2' may be formed through substantially the same process as the fourth semiconductor layer SCP4 of FIG. 6. The first sensing semiconductor layer SCP1' may include a first source region S1', a first drain region D1', and a first channel region A1'. The second sensing semiconductor layer SCP2' may include a second source region S2', a second drain region D2', and a second channel region A2'.

A laminated structure of the first sensing transistor T1' may be substantially the same as that of the first transistor T1 illustrated in FIG. 6. A laminated structure of the second sensing transistor T2' may be substantially the same as that of the fourth transistor T4 illustrated in FIG. 6. In one or more embodiments, the laminated structure of the third sensing transistor T3' may be substantially the same as that of the first sensing transistor T1'.

A connection electrode CNE' may include a first connection electrode CNE1' (or a first sensing connection electrode), a second connection electrode CNE2' (or a second sensing connection electrode), and a third connection electrode CNE3' (or a third sensing connection electrode). The first connection electrode CNE1' may be arranged on the same layer (e.g., may be arranged at the same layer) as the first connection electrode CNE1 illustrated in FIG. 6 and may be connected to the first gate electrode G1' of the first sensing transistor T1' through the first contact hole CH 1'. Hereinafter, the first gate electrode G1' is defined as the first sensing gate electrode G1' so as to be distinguished from the above-described first gate electrode G1.

The second connection electrode CNE2' may be arranged on the same layer as the second connection electrode CNE2 illustrated in FIG. 6 and may be connected to the first connection electrode CNE1' through the second contact hole CH2' defined in the sixth insulating layer INS6. The third connection electrode CNE3' may be arranged on the same layer as the third connection electrode CNE3 illustrated in FIG. 6 and may be connected to the second connection electrode CNE2' through the third contact hole CH3'. The first electrode AE' may be connected to the third connection electrode CNE3' through the fourth contact hole CH4 defined in the eighth insulating layer INS8.

Referring to FIG. 7, the display area DA may include a light receiving area LRA corresponding to the optical sensor SNij and a non-emission area NLEA adjacent to the light receiving area LRA. The non-emission area NLEA may be the non-emission area NLEA illustrated in FIG. 6.

The optical sensing element LRE may include a first electrode AE', a second electrode CE', a hole control layer HCL', an electronic control layer ECL', and a photoelectric conversion layer OPD. The first electrode AE' may be the anode AE' illustrated in FIG. 5, and the second electrode CE' may be the cathode CE' illustrated in FIG. 5. A second opening PDL-OP2 may be defined in the pixel defining layer PDL to expose a suitable portion (e.g., a set or predetermined portion) of the first electrode AE'. The light receiving area LRA may correspond to the second opening PDL-OP2.

The first electrode AE' may be formed through substantially the same process as the first electrode AE illustrated in FIG. 6. The second electrode CE', the hole control layer HCL', and the electronic control layer ECL' may have shapes that are integrated with the second electrode CE', the hole control layer HCL, and the electronic control layer ECL' illustrated in FIG. 6, respectively. The second electrode CE' in FIG. 7 and the second electrode CE in FIG. 6 may be different areas of the common electrode. The common electrode may be deposited to have an integrated shape through an open mask. The hole control layer HCL' in FIG. 7 and the hole control layer HCL in FIG. 6 may also be different regions of the common hole control layer, and the electronic control layer ECL' in FIG. 7 and the electronic control layer ECL in FIG. 6 may also be different regions of the common hole control layer.

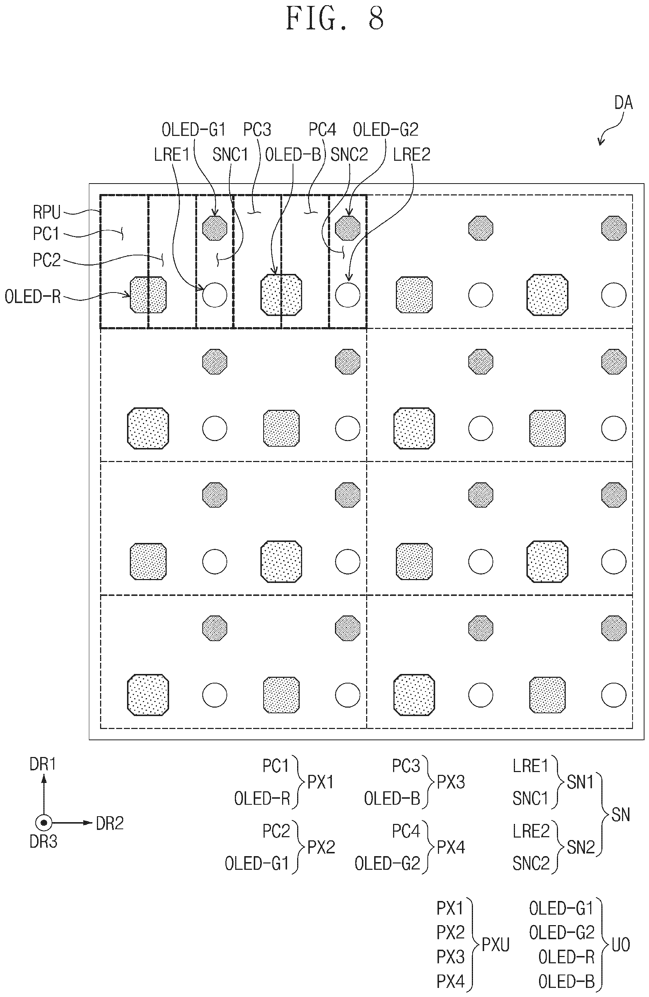

FIG. 8 is a view illustrating a planar arrangement of the light emitting elements OLED and the optical sensing elements LRE, which are arranged on a partial area of the display area illustrated in FIG. 4.

FIG. 8 illustrates unit areas RPU arranged on a first area of the display area DA. At least one pixel PX1, PX2, PX3, and PX4 and an optical sensor SN are arranged corresponding to each of the unit areas RPU. A combination of the pixels PX1, PX2, PX3, and PX4 respectively corresponding to the unit areas RPU may be defined as a unit pixel PXU.

The unit areas RPU may be arranged throughout the display area DA, but are not necessarily limited thereto. The unit areas having different types (kinds) from the previously described unit areas RPU may be arranged on the second area of the display area DA. For example, the optical sensor SN might not be arranged on the unit areas arranged on the second area of the display area DA.

In this embodiment, the unit pixel PXU includes first to fourth pixels PX1, PX2, PX3, and PX4. However, the number of pixels of the unit pixel PXU may vary. The first pixel PX1 may include a first light emitting element OLED-R and a first driving circuit PC1 electrically connected to the first light emitting element OLED-R, the second pixel PX2 may include a second-1 light emitting element OLED-G1 and a first driving circuit PC2 electrically connected to the second-1 light emitting element OLED-G1, the third pixel PX3 may include a third light emitting element OLED-B and a first driving circuit PC3 electrically connected to the third light emitting element OLED-B, and the fourth pixel PX4 may include a second-2 light emitting element OLED-G2 and a first driving circuit PC4 electrically connected to the second-2 light emitting element OLED-G2. For example, the four first driving circuits PC1, PC2, PC3, and PC4 may be defined as a first-1 driving circuit PC1, a first-2 driving circuit PC2, a first-3 driving circuit PC3, and a first-4 driving circuits PC4.

The optical sensor SN may include first and second optical sensors SN1 and SN2. However, the number of optical sensors SN corresponding to the unit pixel PXU may vary. The first optical sensor SN1 may include a first optical sensing element LRE1 and a second driving circuit SNC1 electrically connected to the first optical sensing element LRE1, and the second optical sensor SN2 may include a second optical sensing element LRE2 and a second driving circuit SNC2 electrically connected to the second optical sensing element LRE2.

A first, second-1, third, and second-2 light emitting elements OLED-R, OLED-G1, OLED-B, and OLED-G2 of the unit pixel PXU and the first and second optical sensing elements LRE1 and LRE2 may be arranged to overlap each other on each of the unit areas RPU. Hereinafter, the light emitting elements OLED-R, OLED-G1, OLED-B, and OLED-G2 corresponding to the unit pixels PXU may be defined as unit light emitting elements UO. The arrangements of the unit light emitting element UO and the first and second optical sensing elements LRE1 and LRE2 of the unit areas RPU may be the same.

The first light emitting element OLED-R may generate first color light, for example red light, the second-1 light emitting element OLED-G1 and the second-2 light emitting element OLED-G2 may generate second color light, for example green light, and the third light emitting element OLED-B may generate third color light, for example, blue light. An emission area of the third light emitting element OLED-B may be the largest, and emission areas of the second-1 light emitting element OLED-G1 and the second-2 light emitting element OLED-G2 may be the smallest.

In this embodiment, the first light emitting element OLED-R and the third light emitting element OLED-B may be arranged on the same line, and the first light emitting element OLED-R and the third light emitting element OLED-B may be spaced (e.g., spaced apart or separated)from each other in the second direction DR2. The first optical sensing element LRE1 may be arranged between the first light emitting element OLED-R and the third light emitting element OLED-B in the second direction DR2. The third light emitting element OLED-B may be arranged between the first optical sensing element LRE1 and the second optical sensing element LRE2 in the second direction DR2. The second-1 light emitting element OLED-G1 and the second-2 light emitting element OLED-G2 may be arranged on the same line, but the first light emitting element OLED-R and the third light emitting element OLED-B may be arranged on different lines. The second-1 light emitting element OLED-G1 may be arranged at one side of the first optical sensing element LRE1 in the first direction DR1, and the second-2 light emitting element OLED-G2 may be arranged at one side of the second optical sensing element LRE2 in the first direction DR1. In this embodiment, the second-1 light emitting element OLED-G1 may be arranged above the first optical sensing element LRE1.

In one or more embodiments, one of the first optical sensing element LRE1 and the second optical sensing element LRE2 may not be provided. In sone or more embodiments, the optical sensing element may be further arranged above the first light emitting element OLED-R in the first direction DR1, or the optical sensing element may be arranged above the third light emitting element OLED-B in the first direction DR1. For example, four optical sensors SN may be arranged to correspond to the unit areas RPU.

In one or more embodiments, the unit areas RPU may be divided based on the arrangement of the first driving circuits PC1, PC2, PC3, and PC4 and the second driving circuits SNC1 and SNC2. The four first driving circuits PC1, PC2, PC3, and PC4 and the two second driving circuits SNC1 and SNC2 may be arranged on each of the unit areas RPU. As discussed above, the four first driving circuits PC1, PC2, PC3, and PC4 may be defined as a first-1 driving circuit PC1, a first-2 driving circuit PC2, a first-3 driving circuit PC3, and a first-4 driving circuits PC4, and the two second driving circuits SNC1 and SNC2 may be defined as a second-1 driving circuit SNC1 and a second-2 driving circuit SNC2.

Each of the first light emitting device OLED-R, the second-1 light-emitting device OLED-G1, the third light emitting device OLED-B, and the second-2 light emitting device OLED-G2 may overlap or not overlap a corresponding driving circuit of the first-1 driving circuit PC1, the first-2 driving circuit PC2, the first-3 driving circuit PC3, and the first-4 driving circuit PC4 on the plane. For example, if (e.g., when) the third connection electrode CNE3 in FIG. 6 has an extending shape on the plane, the light emitting element OLED connected to the third connection electrode CNE3 might not overlap the corresponding first-2 driving circuit PC2, like the second-1 light emitting element OLED-G1.

Although all the first-1 driving circuit PC1, the first-2 driving circuit PC2, the first-3 driving circuit PC3, the first-4 driving circuit PC4, the first light emitting element OLED-R, the second-1 light emitting element OLED-G1, the third light emitting element OLED-B, and the second-2 light emitting element OLED-G2 are described as being arranged within the unit areas RPU, embodiments of the present disclosure are not necessarily limited thereto. In one or more embodiments, one of the four first driving circuits PC1, PC2, PC3, and PC4 arranged on the first unit area of the unit areas RPU may be connected to one of the first light emitting element OLED-R, the second-1 light emitting element OLED-G1, the third light emitting element OLED-B, and the second-2 light emitting element OLED-G2, which are arranged on the second unit area adjacent to the first unit area. For example, if (e.g., when) the third connection electrode CNE3 in FIG. 6 further extends from the first unit area to the second unit area on the plane, the driving circuit arranged on the first unit area and the light emitting element arranged on the second unit area may constitute one pixel.

In addition, it has been described that all the second-1 and second-2 driving circuits SNC1 and SNC2 and the first and second optical sensing elements LRE1 and LRE2 are arranged within the unit areas RPU, but embodiments of the present disclosure are not necessarily limited thereto. For example, if (e.g., when) the third connection electrode CNE3 in FIG. 6 further extends from the first unit area to the second unit area on the plane, the driving circuit arranged on the first unit area and the optical sensing element arranged on the second unit area may constitute one optical sensor.

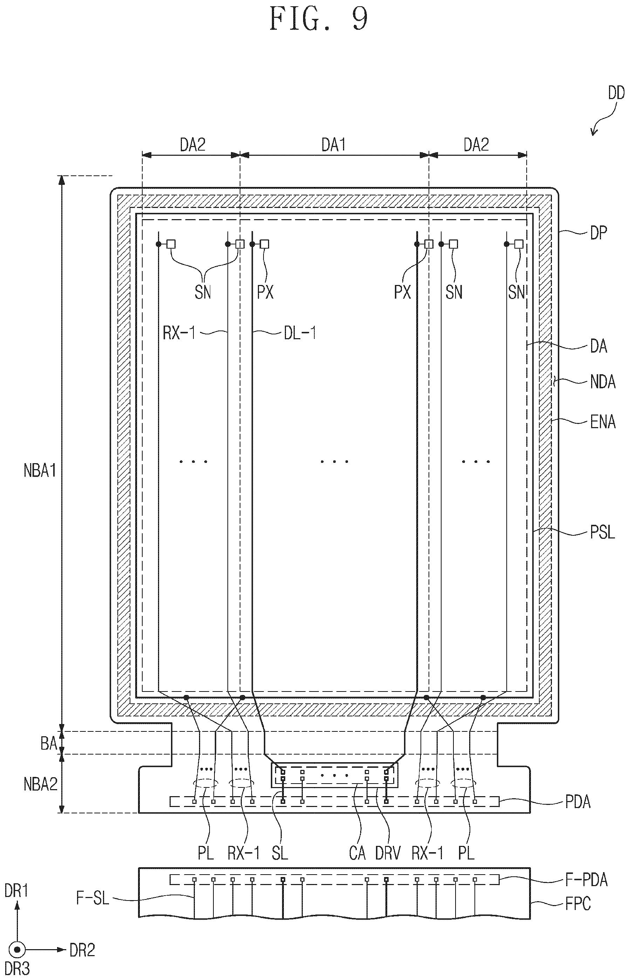

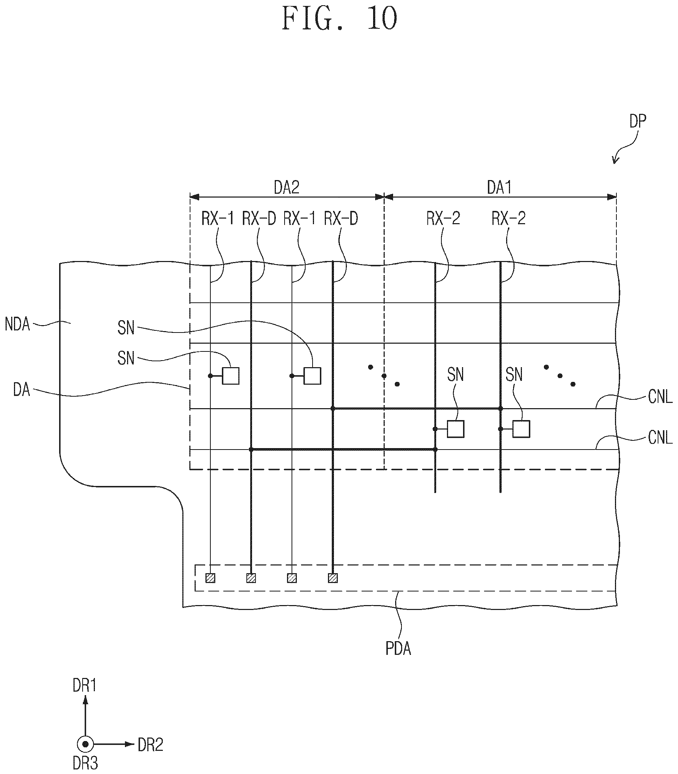

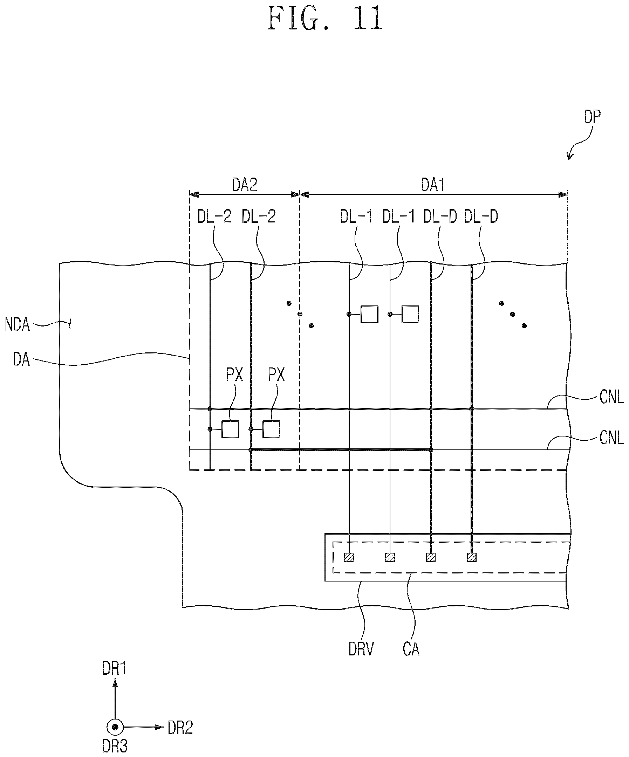

FIG. 9 is a perspective view of a display device DD according to one or more embodiments of the present disclosure. FIG. 10 is a cross-sectional view illustrating a partial area of the display device DD according to one or more embodiments of the present disclosure. FIG. 11 is a cross-sectional view illustrating a partial area of the display device DD according to one or more embodiments of the present disclosure.

Referring to FIG. 9, a display panel DP may include a display area DA and a non-display area NDA around (e.g., surrounding) the display area DA. The display area DA may include a first area DA1 and a second area DA2. In this embodiment, the second areas DA2 arranged at both sides (e.g., opposite sides) of the first area DA1 in the second direction DR2 are illustrated, but embodiments of the present disclosure are not necessarily limited thereto. In one or more embodiments, the second area DA2 may be arranged only at one side of the first area DA1.

The first area DA1 may be an area on which a first data line DL-1 is arranged, as will be described in more detail later, and the second area DA2 may be an area on which a first readout line RX-1 is arranged, as will be described in more detail later. As illustrated in FIG. 10, a dummy readout line RX-D may be further arranged on the second area DA2, and a second readout line RX-2 that is distinct from the first readout line RX-1 may be further arranged on the first area DA1. In addition, as illustrated in FIG. 11, a dummy data line DL-D may be further arranged on the first area DA1, and a second data line DL-2 that is distinct from the first data line DL-1 may be further arranged on the second area DA2.

Referring to FIG. 9, the non-display area NDA may include at least at least a sealing area ENA, a chip area CA, and a pad area PDA. The sealing area ENA, the chip area CA, and the pad area PDA may be sequentially arranged from the display area DA in the first direction DR1. The sealing area ENA may be an area around (e.g., surrounding) the display area DA, but this is not necessarily limited thereto. A detailed description of a sealing area ENA will be described in more detail later.

The pad area PDA may be an area, on which the printed circuit board FPC is bonded, and may be arranged to be further away from the display area DA than the chip area CA in the first direction DR1. The chip area CA may be an area on which the driving chip DRV is mounted.

The display panel DP may be divided into a first area NBA1, a second area NBA2, and a bending area BA in the first direction DR1. The second area NBA2 and the bending area BA may be partial areas of the non-display area NDA. The bending area BA may be arranged between the first area NBA1 and the second area NBA2. As the display panel DP is bent in the bending area BA, the base layer SUB (see FIG. 6) of the first area NBA1 and the base layer SUB (see FIG. 6) of the second area NBA2 may be arranged to adjacently face each other. The bending area BA may be arranged between the sealing area ENA and the pad area PDA in the first direction DR1.

The first data line DL-1 may extend from the chip area CA to the first area DA1 in the first direction DR1 to electrically connect the pixel PX to the driving chip DRV. That the first data line DL-1 is connected to the pixel PX refers to that the first data line DL-1 is connected to the first driving circuits PC1, PC2, and PC3, and PC4 illustrated in FIG. 8. An end of the first data line DL-1 may be arranged on the chip area CA and may be electrically connected to a bump of the driving chip DRV.

The first readout line RX-1 may extend from the pad area PDA to the second area DA2 in the first direction DR1 to electrically connect an optical sensor SN to a printed circuit board FPC. That the first readout line RX-1 is connected to the pixel PX refers to that the first readout line RX-1 is connected to the second driving circuits SNC1 and SNC2 illustrated in FIG. 8. The printed circuit board FPC may include a pad area F-PDA bonded to the pad area PDA and a plurality of signal lines F-SL that transmit signals. One of the signal lines F-SL may be electrically connected to one first readout line RX-1.

The first readout line RX-1 might not overlap the first data line DL-1 within the non-display area NDA. This is done for suppressing coupling between the first readout line RX-1 and the first data line DL-1. In addition, this is done for preventing a data signal periodically applied to the first data line DL-1 from acting as noise on a sensing signal read from the first readout line RX-1.

The power line PL may extend from the pad area PDA along the first direction DR1 within the non-display area NDA. The power line PL may extend up to an area adjacent to the display area DA. The power line PL may be connected to the power supply line PSL adjacent to the display area DA. A power supply line PSL having a closed line shape is illustrated as an example, but embodiments of the present disclosure are not necessarily limited thereto. The second electrode CE' in FIG. 7 and the second electrode CE in FIG. 6 may be different areas of the common electrode, and the common electrode of the plurality of pixels PX and the plurality of optical sensors SN, which are illustrated in FIG. 4, may be connected to the power supply line PSL. In one or more embodiments, additional power lines extending from the power supply line PSL may be further arranged on the display area DA.

The power line PL and the first readout line RX-1 may overlap each other within the non-display area NDA to increase in surface area of the second area DA2. In the area on which the power line PL and the first readout line RX-1 overlap each other, the power line PL and the first readout line RX-1 may arranged on different layers. Even if the power line PL and the first readout line RX-1 overlap each other, a bias voltage applied to the power line PL may act as noise on the sensing signal read from the first readout line RX-1. If the power line PL and the first readout line RX-1 do not overlap each other, the area on which the first readout line RX-1 is arranged may be necessarily limited, and thus, it is difficult to secure a surface area of the second area DA2. This will be described in more detail later in more detail.

In addition, if the power line PL and the first readout line RX-1 are arranged so as not to overlap each other, because an area on which a plurality of first data lines DL-1, a plurality of power lines PL, and a plurality of first readout lines RX-1 are arranged has to be secured, there is a limit to reduce the surface area of the non-display area NDA. This limitation may be solved by allowing the power line PL and the first readout line RX-1 to overlap each other.

Referring to FIG. 9, in the bending area BA, the first data lines DL-1, the power lines PL, and the first readout lines RX-1 might not overlap each other. In some areas of the non-display area NDA arranged between the bending area BA and the display area DA, the first data lines DL-1 and the first readout lines RX-1 might not still overlap each other. In some areas of the non-display area NDA arranged between the bending area BA and the display area DA, the first readout line lines RX-1 may overlap the power lines PL. For example, the first readout lines RX-1 and the power lines PL may cross each other within the sealing area ENA.

The first readout lines RX-1 arranged on a narrow area in the bending area BA may be unfolded after the bending area BA. This is because an interval between the first readout line lines RX-1 within the second area DA2 is larger than that between the first readout line lines RX-1 within the bending area BA. Thus, if the first readout lines RX-1 does not overlap the power lines PL on some areas of the non-display area NDA arranged between the bending area BA and the display area DA, the surface area of the second area DA2 may become narrow.

The first data lines DL-1 arranged on the narrow area in the bending area BA may be unfolded after the bending area BA. The first data lines DL-1 might not undergo an interference from other signal lines on some area of the non-display area NDA arranged between the bending area BA and the display area DA.

A signal line SL extending from the pad area PDA to the chip area CA to electrically connect the printed circuit board FPC to the driving chip DRV may be further arranged on the non-display area NDA of the display panel DP. The signal line SL may be to transmit the first control signal DCS and the image data signal DATA, which are described with reference to FIG. 4, to the driving chip DRV.

Referring to FIG. 10, the surface area of the light sensing area may increase through a bypass line design. As illustrated in FIG. 10, the optical sensor SN electrically connected to the printed circuit board FPC of FIG. 9 may be arranged on the first area DA1 through the bypass line design. When the optical sensor SN arranged on the second area DA2 is defined as the first optical sensor, the optical sensor SN arranged on the first area DA1 may be defined as the second optical sensor.

A dummy readout line RX-D extending from the pad area PDA in the first direction DR1 may be arranged on the second area DA2. A second readout line RX-2 extending in the first direction DR1 may be arranged on the first area DA1. Unlike the first readout line RX-1, the second readout line RX-2 might not be a signal line extending from the pad area PDA, and the second readout line RX-2 may have a length less than that of the first readout line RX-1 and might not overlap the sealing area ENA and/or the banding area BA of FIG. 9. The second readout line RX-2 and the dummy readout line RX-D may be connected to each other by a connection line CNL extending in the second direction DR2.

The unit pixel PXU illustrated in FIG. 8 may be arranged on each of the first area DA1 and the second area DA2. Each of the first and second optical sensors SN1 and SN2 (e.g., SN: SN1, SN2, see FIG. 8) of the first area DA1 may be connected to the second readout line RX-2, and each of the first and second optical sensors SN1 and SN2 of the second area DA2 may be connected to the first readout line RX-1 .

Referring to FIG. 11, the pixels PX may be arranged on the second area DA2 through the bypass line design. As illustrated in FIG. 11, the pixels PX electrically connected to the driving chip DRV may be arranged on the second area DA2 through the bypass line design. When the pixel PX arranged on the first area DA1 is defined as a first pixel, the pixel PX arranged on the second area DA2 may be defined as a second pixel.

The dummy data line DL-D extending from the chip area CA in the first direction DR1 may be arranged on the first area DA1. The second data line DL-2 extending in the first direction DR1 may be arranged on the second area DA2. Unlike the first data line DL-1, the second data line DL-2 might not be a signal line extending from the chip area CA, and the second data line DL-2 may have a length less than that of the first data line DL-1 and might not overlap the sealing area ENA and/or the banding area BA of FIG. 9. The second data line DL-2 and the dummy data line DL-D may be connected to each other by the connection line CNL extending in the second direction DR2.

The unit pixel PXU illustrated in FIG. 8 may be arranged on each of the first area DA1 and the second area DA2. Each of the first to fourth pixels PX1, PX2, PX3, and PX4 of the first area DA1 may be connected to the first data line DL-1, and each of the first to fourth pixels PX1, PX2, PX3, and PX4 of the second area DA2 may be connected to the second data line DL-1.

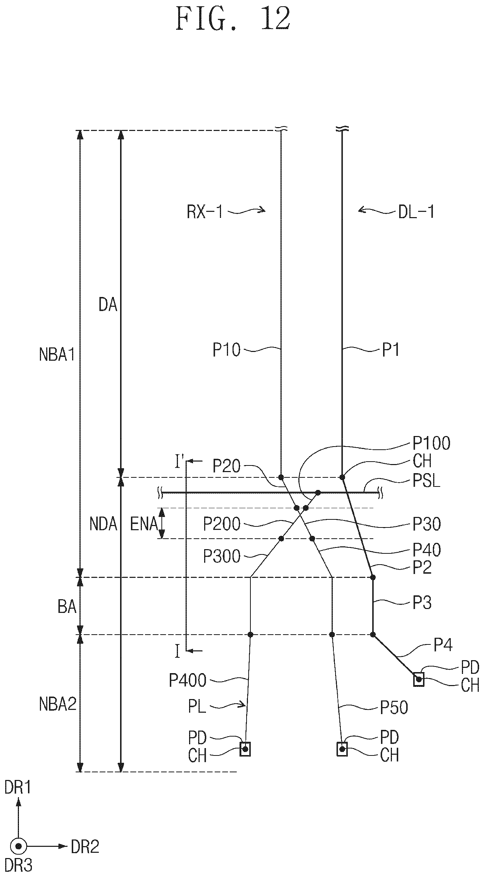

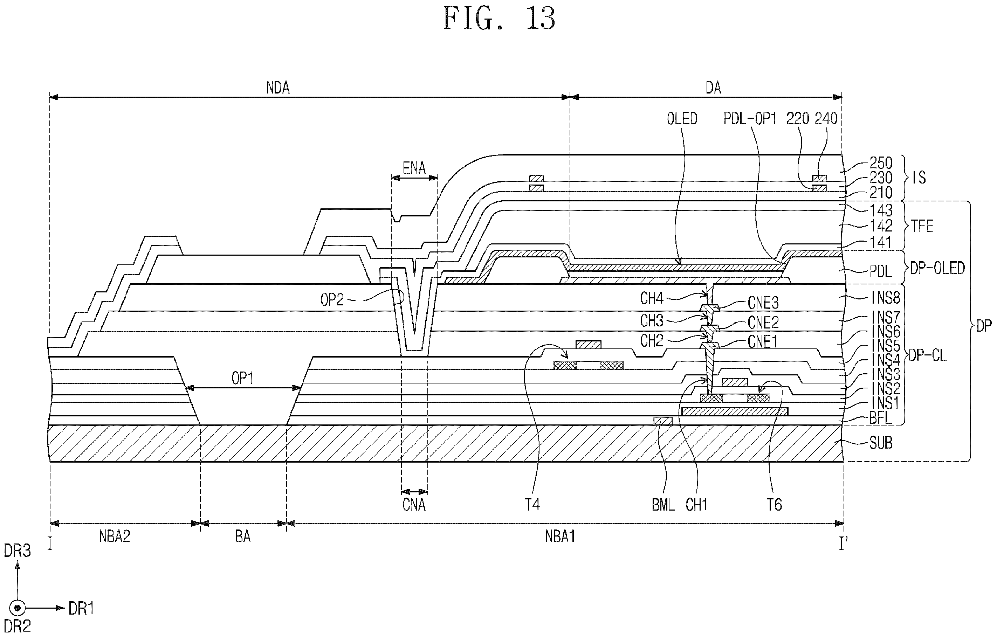

FIG. 12 is a plan view illustrating the data line DL-1, the readout line RX-1, and the power line PL according to one or more embodiments of the present disclosure. FIG. 13 is a cross-sectional view taken along the line I-I' of FIG. 12.

In FIG. 12, one of the first data lines DL-1 of FIG. 9 is illustrated, one of the first readout line lines RX-1 of FIG. 9 is illustrated, and one of the power lines PL of FIG. 9 is illustrated.

Each of the first data line DL-1, the first readout line RX-1, and the power line PL may include a plurality of portions arranged on different layers depending on the area. The first data line DL-1 may include first to fourth portions P1 to P4, the first readout line RX-1 may include first to fifth portions P10 to P50, and the power line PL may include first to fourth portions P100 to P400. When one of the plurality of portions is referred to as a first portion, the other potion may be simply referred to as a second portion, and the names of the portions are not necessarily limited to an arrangement order of the portions.

The first portion P1 of the first data line DL-1 overlapping the display area DA of the first area NBA1 may be formed from one of the first source/drain layer, the second source/drain layer, and the third source/drain layer, which are described with reference to FIGs. 6 and 7. In this embodiment, the first portion P1 of the first data line DL-1 may be formed from the third source/drain layer. The second portion P2 of the first data line DL-1 overlapping the non-display area NDA of the first area NBA1 may be formed from one of the first gate layer, the second gate layer, and the third gate layer, which are described with reference to FIGs. 6 and 7. In this embodiment, the second portion P2 of one first data line DL-1 may be formed from the first gate layer, and the second portion P2 of the other first data line DL-1 adjacent thereto may be formed from the second gate layer. The second portion P2 of the first data line DL-1 may be connected to the first portion P1 through a contact hole CH. The adjacent portions of the first to fourth portions P1 to P4 may be connected to each other through the contact hole CH. An insulating layer through which the contact hole CH passes may be changed depending on a laminated position of the first portion P1 and a laminated position of the second portion P2. Although the contact hole CH is illustrated as being defined at a boundary between the adjacent areas, the contact hole CH may be defined in one of the adjacent areas. The contact hole CH might not be defined in the bending area BA.

The third portion P3 of the first data line DL-1 overlapping the bending area BA may be formed from one of the first source/drain layer, the second source/drain layer, and the third source/drain layer, which are described with reference to FIGs. 6 and 7. The third portion P3 may be arranged far away from the base layer SUB (see FIG. 6) so that tensile stress is applied to the first data line DL-1 during the bending. The third portion P3 of first data line DL-1 may be formed from the third source/drain layer. In this embodiment, the third portion P3 of one first data line DL-1 may be formed from the second source/drain layer, and the third portion P3 of the other first data line DL-1 adjacent thereto may be formed from the third source/drain layer.

The fourth portion P4 of the first data line DL-1 overlapping the second area NBA2 may be formed from one of the first gate layer, the second gate layer, and the third gate layer, which are described with reference to FIGs. 6 and 7. In this embodiment, the fourth portion P4 of one first data line DL-1 may be formed from the first gate layer, and the fourth portion P4 of the other first data line DL-1 adjacent thereto may be formed from the second gate layer. The fourth portion P4 of the first data line DL-1 may be connected to the pad electrode PD through the contact hole CH. The second portion P2 of the first data line DL-1 formed from the first gate layer may be connected to the third portion P3 of the first data line DL-1 formed from the third source/drain layer. For processing reasons, resistance may vary for each gate layer, and thus, a resistance deviation may occur between the first data line DL-1 formed from the first gate layer and the first data line DL-1 formed from the third source/drain layer. Here, the resistance deviation between the first data lines DL-1 may be reduced by the portions in which the first data lines DL-1 are formed from different gate layers, respectively.

The first portion P10 of the first readout line RX-1 overlapping the display area DA of the first area NBA1 may be formed from one of the first source/drain layer, the second source/drain layer, and the third source/drain layer, which are described with reference to FIGs. 6 and 7. In this embodiment, the first portion P10 of the first readout line RX-1 may be formed from the third source/drain layer.

The second portion P20 of the first readout line RX-1 arranged between the display area DA and the sealing area ENA may be formed from one of the shielding layer, the first gate layer, the second gate layer, and the third gate layer, which are described with reference to FIGs. 6 and 7. The third portion P30 of the first readout line RX-1 arranged on the sealing area ENA may be arranged on a different layer from the power line PL. In one or more embodiments, the second portion P20 of the first readout line RX-1 and the third portion P30 of the first readout line RX-1 may be arranged on the same layer and integrated with each other.

The fourth portion P40 of the first readout line RX-1 arranged from the area after the sealing area ENA to the banding area BA (e.g., the fourth portion P40 of the first readout line RX-1 arranged in an area between the sealing area ENA and the bending area BA) may be formed from one of the first source/drain layer, the second source/drain layer, and the third source/drain layer, which are described with reference to FIGs. 6 and 7. In one or more embodiments, the area between the sealing area ENA and the bending area BA may not be provided or may be formed to be narrowed that it may be ignored.

When the bending is performed, the fourth portion P40 of the first readout line RX-1 may be formed from the second source/drain layer or the third source/drain layer so that the tensile stress is applied to the fourth portion P40 of the first readout line RX-1. In this embodiment, the fourth portion P40 of one first readout line RX-1 may be formed from the second source/drain layer, and the fourth portion P40 of the other first readout line RX-1 adjacent thereto may be formed from the third source/drain layer.

The fifth portion P50 of the first readout line RX-1 overlapping the second area NBA2 may be formed from one of the first source/drain layer, the second source/drain layer, and the third source/drain layer, which are described with reference to FIGs. 6 and 7. In this embodiment, the fifth portion P50 of the first readout line RX-1 may be formed from the second source/drain layer. The fifth portion P50 of the first readout line RX-1 may be connected to the pad electrode PD through the contact hole CH. The adjacent portions of the first to fifth portions P10 to P50 may be connected to each other through the contact hole CH. In one or more embodiments, at least two adjacent portions of the first to fifth portions P10 to P50 may be arranged on the same layer and have an integrated shape.

The first portion P100 of the power line PL arranged between the display area DA and the sealing area ENA may be formed from one of the first source/drain layer, the second source/drain layer, and the third source/drain layer, which are described with reference to FIGs. 6 and 7. In one or more embodiments, the first portion P100 of the power line PL may be arranged on the same layer as the power supply line PSL.

The second portion P200 of the power line PL arranged on the sealing area ENA may be formed from one of the first gate layer, the second gate layer, and the third gate layer, which are described with reference to FIGs. 6 and 7. The second portion P200 of the power line PL may have a double line structure. The second portion P200 of the power line PL may include a portion formed from the second gate layer and a portion formed from the third gate layer. In one or more embodiments, the third portion P300 of the power line PL arranged from an area after the sealing area ENA to the bending area BA (e.g., the third portion P300 of the power line PL arranged in an area between the sealing area ENA and the bending area BA) may be formed from one of the first source/drain layer, the second source/drain layer, and the third source/drain layer, which are described with reference to FIGs. 6 and 7.

The fourth portion P400 of the power line PL overlapping the second area NBA2 may be formed from one of the first source/drain layer, the second source/drain layer, and the third source/drain layer, which are described with reference to FIGs. 6 and 7. The fourth portion P400 of the power line PL may have a double line structure. The fourth portion P400 of the power line PL may include at least two portions of the portion formed from the first source/drain layer, the portion formed from the second source/drain layer, and the portion formed from the third source/drain layer.

The fourth portion P400 of the power line PL may be connected to the pad electrode PD through the contact hole CH. The adjacent portions of the first to fourth portions P100 to P400 may be connected to each other through the contact hole CH. In one or more embodiments, at least two adjacent portions of the first to fourth portions P100 to P400 may be arranged on the same layer and have an integrated shape.

Referring to FIG. 13, the buffer layer BFL to the eighth insulating layer INS8 may be arranged on the base layer SUB. In this embodiment, the buffer layer BFL to the fifth insulating layer INS5 may be an inorganic layer, and the sixth insulating layer INS6 to the eighth insulating layer INS8 may be an organic layer.

In FIG. 12, the fourth transistor T4 and the sixth transistor T6 of FIG. 6 are briefly illustrated. An opening OP1 (hereinafter, referred to as a first opening) corresponding to the bending area BA may be defined in the buffer layer BFL to the fifth insulating layer INS5. The first opening OP1 may extend in the second direction DR2. The first opening OP1 may be defined to prevent or reduce the buffer layer BFL to the fifth insulating layer INS5 from being damaged by stress if (e.g., when) the non-display area NDA is bent.

An opening OP2 (hereinafter, referred to as a second opening) corresponding to the sealing area ENA may be defined in the sixth to eighth insulating layers INS6 to INS8. The second opening OP2 may extend in the second direction DR2 to expose the fifth insulating layer INS5 that is the uppermost inorganic layer. A partial area CNA (hereinafter, referred to as a contact area) of the fifth insulating layer INS5 may be exposed from the sixth to eighth insulating layers INS6 to INS8 through the second opening OP2. The thin film encapsulation layer TFE may be arranged inside the second opening OP2 and may be in contact with the contact area CNA of the fifth insulating layer INS5. The thin film encapsulation layer TFE that seals the display element layer DP-OLED may include a first inorganic encapsulation layer 141, an organic encapsulation layer 142, and a second inorganic encapsulation layer 143, which are sequentially laminated. However, the layers constituting the thin film encapsulation layer 140 are not necessarily limited thereto. The first inorganic encapsulation layer 141 and/or the second inorganic encapsulation layer 143 may be in contact with the insulating layer INS5 to protect the display device layer DP-OLED from external moisture.

The input sensor IS arranged on the display panel DP may include at least one conductive layer and at least one insulating layer. In this embodiment, the input sensor IS may include a first insulating layer 210, a first conductive layer 220, a second insulating layer 230, a second conductive layer 240, and a third insulating layer 250.

The first insulating layer 210 may be directly arranged on the display panel DP. The first insulating layer 210 may include an inorganic layer including at least one of silicon nitride, silicon oxynitride, and/or silicon oxide. Each of the first conductive layer 220 and the second conductive layer 240 may have a single-layered structure or a multilayered structure in which a plurality of layers are laminated in the third directional axis DR3. The first conductive layer 220 and the second conductive layer 240 may include conductive lines defining mesh-shaped electrodes.

The second insulating layer 230 may cover the first conductive layer 220. The first insulating layer 230 may include an inorganic layer including at least one of silicon nitride, silicon oxynitride, and/or silicon oxide. The third insulating layer 250 may cover the second conductive layer 240. The third insulating layer 250 may include an organic layer. The first insulating layer 210, the second insulating layer 230, and the third insulating layer 250 may be sequentially laminated. An opening corresponding to the bending area BA may be defined in the first insulating layer 210 and the second insulating layer 230.

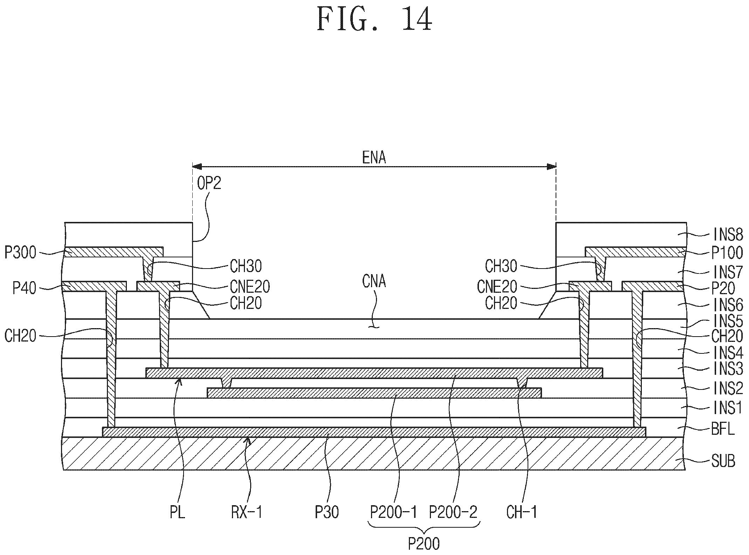

FIGs. 14 - 16 are cross-sectional views illustrating a sealing portion ENA of the display device DP according to one or more embodiments of the present disclosure.

In FIGs. 14 - 16, the first readout line RX-1 and the power line PL, which are arranged on the sealing area ENA, are illustrated in one cross-section to be compared to each other. Except for the area on which the first readout line RX-1 and the power line PL are crossed with each other, the first readout line RX-1 and the power line PL might not overlap each other, but the first readout line RX-1 and the power line PL may be illustrated in one cross-section to be compared to each other. The plurality of portions of each of the first readout line RX-1 and the power line PL illustrated in FIGs. 14-16 may be described as some of the plurality of portions illustrated in FIG. 12.

Referring to FIG. 14, the third portion P30 of the first readout line RX-1 may be arranged below the buffer layer BFL. The shielding electrode BML and the third portion P30 of the first readout line RX-1 described with reference to FIG. 6 may be formed through substantially the same process. As illustrated in FIG. 14, the second portion P20 and the fourth portion P40 of the first readout line RX-1 may be arranged on the sixth insulating layer INS6. Each of the first portion P20 and the fourth portion P40 of the first readout line RX-1 may be connected to the third portion P30 of the first readout line RX-1 through the contact hole CH20. The contact hole CH20 may be formed through substantially the same process as the second contact hole CH2 in FIG. 6 or may be formed through an additional etching process. In one or more embodiments, the first portion P20 and the fourth portion P40 of the first readout line RX-1 may be arranged on the seventh insulating layer INS7 within an area that does not interfere with the power line PL.

The second portion P200 of the power line PL may be arranged between the first insulating layer INS1 and the third insulating layer INS3. In this embodiment, the second portion P200 of the power line PL may include a second-1 portion P200-1 and a second-2 portion P200-2, which are arranged on different layers. The second-1 part P200-1 and the second-2 portion P200-2 may be connected to each other through the contact hole CH-1. This double line structure may reduce the resistance of the power line PL. In one or more embodiments, one of the second-1 portion P200-1 and the second-2 portion P200-2 may not be provided.

As illustrated in FIG. 14, the first portion P100 and the third portion P300 of the power line PL may be arranged on the seventh insulating layer INS7. Each of the first portion P100 and the third portion P300 of the power line PL may be connected to the second portion P200 of the power line PL through the connection electrode CNE20 arranged on the sixth insulating layer INS6. The connection electrode CNE20 may be connected to the second portion P200 of the power line PL through the contact hole CH20. The contact hole CH20 may be formed through substantially the same process as the second contact hole CH2 in FIG. 6. Each of the first portion P100 and the third portion P300 of the power line PL may be connected to the connection electrode CNE20 through the contact hole CH30. The contact hole CH30 may be formed through substantially the same process as the third contact hole CH3 in FIG. 6.

In one or more embodiments, the connection electrode CNE20 may not be provided, and each of the first portion P100 and the third portion P300 of the power line PL may be directly connected to the second portion P200 of the power line PL. In one or more embodiments, each of the first portion P100 and the third portion P300 of the power line PL may be connected to the second portion P200 of the power line PL through the connection electrode arranged on the fifth insulating layer (INS5).

According to this embodiment, the third portion P30 of the first readout line RX-1 and the second portion P200 of the power line PL may be arranged below the fifth insulating layer INS5 and thus may be protected from a wet etching process that forms the opening PDL-OP2. For example, if the third portion P30 of the first readout line RX-1 or the second portion P200 of the power line PL are formed from the first source/drain layer arranged on the fifth insulating layer INS5, a limitation of corrosion of the corresponding line may occur.

The third portion P30 of the first readout line RX-1 may be arranged below the first insulating layer INS1 to reduce noise. In one or more embodiments, the second portion P2 of the first data line DL-1 in FIG. 12 may be arranged on the same layer as the second-1 portion P200-1 or the second-2 portion P200-2, and the first portion P1 and the third portion P3 of the first data line DL-1 in FIG. 12 may be arranged on the same layer as the first portion P100 of the power line PL. Thus, the third portion P30 of the first readout line RX-1 arranged below the first insulating layer INS1 may be relatively spaced far from the first data line DL-1.

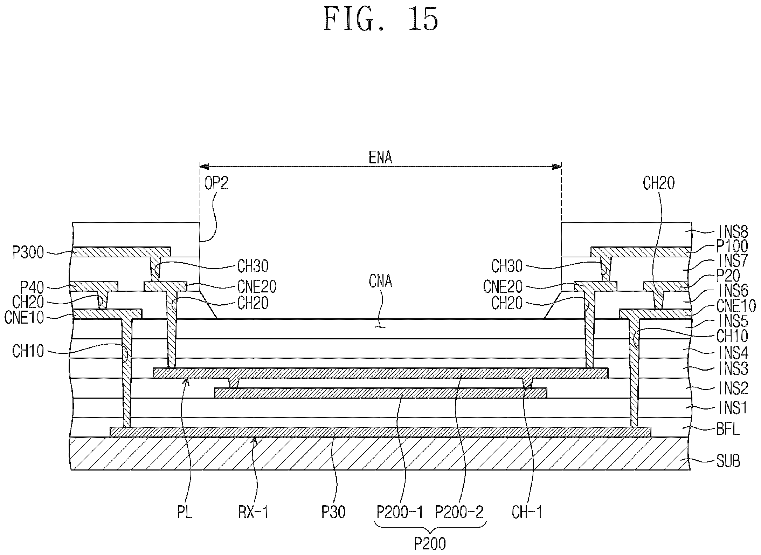

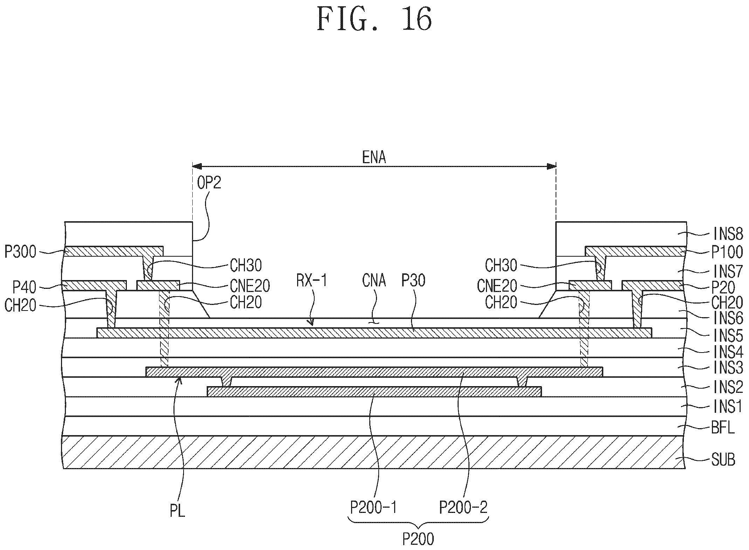

Hereinafter, the description and differences between the first readout line RX-1 and the power line PL of FIG. 14 will be described with reference to FIGs. 15 and 16.

Referring to FIG. 15, each of the second portion P20 and the fourth portion P40 of the first readout line RX-1 may be connected to the third portion P30 of the first readout line RX-1 through the connection electrode CNE10 arranged on the fifth insulating layer INS5. Each of the second portion P20 and the fourth portion P40 of the first readout line RX-1 may be connected to the connection electrode CNE10 through the contact hole CH20. The contact hole CH20 may be formed through substantially the same process as the second contact hole CH2 in FIG. 6. The connection electrode CNE10 may be connected to the third portion P30 of the first readout line RX-1 through the contact hole CH10. The contact hole CH10 may be formed through substantially the same process as the first contact hole CH1 of FIG. 6.

In one or more embodiments, the second portion P20 and the fourth portion P40 of the first readout line RX-1 may be arranged on the seventh insulating layer INS7. Here, the second portion P20 and the fourth portion P40 of the first readout line RX-1 may be connected to the third portion P30 of the first readout line RX-1 through the connection electrode arranged on the sixth insulating layer INS6 and the connection electrode arranged on the fifth insulating layer INS5. For example, the connection relationship between the second portion P20 of the first readout line RX-1 and the third portion P30 of the first readout line RX-1 may be similar to that between the sixth semiconductor layer SCP6 of FIG. 6 and the third connection electrode CNE3.

Referring to FIG. 16, the third portion P30 of the first readout line RX-1 may be arranged on the fourth insulating layer INS4. Each of the second portion P20 and the fourth portion P40 of the first readout line RX-1 may be connected to the third portion P30 of the first readout line RX-1 through the contact hole CH20. In FIG. 16, the contact hole CH20 connecting the connection electrode CNE20 to the second portion P200 of the power line PL may be arranged on an area that does not interfere with the third portion P30 of the first readout line RX-1. In this sense, the contact hole CH20 may be shown as a dotted line.

In one or more embodiments, each of the second portion P20 and the fourth portion P40 of the first readout line RX-1 may be connected to the third portion P30 of the first readout line RX-1 through the connection electrode arranged on the fifth insulating layer INS5.

As discussed, embodiments may provide a display device comprising: a base layer comprising a display area comprising a first area and a second area adjacent to the first area in a first direction, and a non-display area comprising a chip area and a pad area, wherein the pad area is located farther from the display area than the chip area in a second direction crossing the first direction; a driving chip in the chip area; a first pixel in the first area and comprising a first light emitting element; a first optical sensor in the second area; a first data line extending from the chip area to the first area and electrically connecting the first pixel to the driving chip; a first readout line extending from the pad area to the second area and electrically connected to the first optical sensor; and a power line extending from the pad area, wherein the power line overlaps the first readout line in an area of the non-display area, wherein the first data line and the first readout line do not overlap each other in the non-display area, and wherein the first readout line and the power line are on different layers in the area of the non-display area on which the first readout line and the power line overlap each other.

In some embodiments, the first data line extends in the first direction in the display area.

In some embodiments, the first readout line extends in the first direction in the display area.

In some embodiments, the power line may extend up to an area adjacent to the display area. The power line may be connected to a power supply line adjacent to the display area. The power supply line may have a closed line shape surrounding the display area.

In some embodiments, the display area may include two second areas, with the second areas being arranged at opposite sides of the first area in the second direction.

The display area may be part of a first non-bending area. The chip area and a pad area may be part of a second non-bending area. A bending area may be provided between the first and second non-bending areas.

In some embodiments, a signal line may extend from the pad area to the chip area to electrically connect a printed circuit board to the driving chip.

The first pixel in the first area may comprise a number of sub-pixels, forming a unit pixel. A plurality of unit pixels may be formed in the first area. Each unit pixel may comprise a light emitting element and an optical sensor.

The unit pixels in the first area may be connected to data lines that extend from the chip area.

A plurality of unit pixels may be formed in the second area. The unit pixels in the second area may be connected to the data lines that extend from the chip area in a bypass manner, i.e. connected via connection lines that extend in the second direction. For example, second data lines in the second area may be connected to connection lines, that are in turn connected to first data lines in the first area.

A second readout line that is distinct from the first readout line may be further arranged on the first area.

A dummy readout line extending from the pad area in the first direction may be arranged on the second area. A second readout line extending in the first direction may be arranged on the first area. The second readout line and the dummy readout line may be connected to each other by a connection line extending in the second direction.

According to one or more embodiments of the present disclosure, the readout line and the power line may be arranged to overlap each other in the non-display area, thereby simplifying the line design so as to increase in surface area of the light sensing area. The light sensing area corresponding to the second area may be secured using the first readout line. To further increase in light sensing area on the first area, the dummy readout line, the second readout line, and the connection lines may be further desired or required, and thus, the line design may be more complicated.

The readout line and the power line may be arranged to overlap each other in the non-display area, thereby reducing the surface area of the non-display area.

It will be apparent to those skilled in the art that one or more suitable modifications and variations can be made in the present disclosure. Thus, it is intended that the present disclosure covers the modifications and variations of embodiments provided they come within the scope of the appended claims and their equivalents. Thus, to the maximum extent allowed by law, the scope of the present disclosure is to be determined by the broadest permissible interpretation of the following claims and equivalents thereof and their equivalents, and shall not be restricted or limited by the foregoing detailed description.

## Claims

1. A display device comprising:
a base layer comprising a display area comprising a first area and a second area adjacent to the first area in a first direction, and a non-display area comprising a chip area and a pad area, wherein the pad area is located farther from the display area than the chip area in a second direction crossing the first direction;
a driving chip in the chip area;
a first pixel in the first area and comprising a first light emitting element;
a first optical sensor in the second area;
a first data line extending from the chip area to the first area and electrically connecting the first pixel to the driving chip;
a first readout line extending from the pad area to the second area and electrically connected to the first optical sensor; and
a power line extending from the pad area, wherein the power line overlaps the first readout line in an area of the non-display area,
wherein the first data line and the first readout line do not overlap each other in the non-display area, and
wherein the first readout line and the power line are on different layers in the area of the non-display area on which the first readout line and the power line overlap each other.

2. The display device of claim 1, further comprising:
a plurality of inorganic layers on the base layer arranged to overlap the display area and the non-display area;
a plurality of organic layers on the plurality of inorganic layers and exposing a contact area of an uppermost inorganic layer of the plurality of inorganic layers within the non-display area; and
a thin film encapsulation layer on the plurality of organic layers to cover the first light emitting element and in contact with the contact area of the uppermost inorganic layer.

3. The display device of claim 2, wherein the non-display area further comprises a sealing area corresponding to the contact area of the uppermost inorganic layer, and
wherein the first readout line and the power line overlap each other in the sealing area.

4. The display device of claim 3, wherein the first readout line and the power line are located below the uppermost inorganic layer in the sealing area.

5. The display device of claim 3 or 4, wherein the first data line and the power line are on the same layer within the sealing area.

6. The display device of any one of claims 3 to 5, wherein the sealing area is located between the display area and the chip area in the second direction.

7. The display device of any one of claims 3 to 6, wherein the first pixel further comprises a shielding electrode, a dummy electrode, a first transistor, and a second transistor,
wherein the first transistor comprises a silicon semiconductor layer and a first gate electrode on the silicon semiconductor layer,
the second transistor comprises an oxide semiconductor layer on the first gate electrode and a second gate electrode on the oxide semiconductor layer,
the dummy electrode is located between the first gate electrode and the second gate electrode, and
the shielding electrode is located below the silicon semiconductor layer.

8. The display device of claim 7, wherein the first readout line comprises a first portion on the same layer as the shielding electrode within the sealing area, and
the power line comprises a first portion on the same layer as the first gate electrode or the dummy electrode within the sealing area.

9. The display device of claim 8, wherein the non-display area further comprises a bending area between the sealing area and the pad area,
the first readout line further comprises a second portion on a different layer from the first portion of the first readout line within the bending area, and
the power line further comprises a second portion on a different layer from the first portion of the power line within the bending area.

10. The display device of any one of claims 7 to 9, wherein the first readout line comprises a first portion on the same layer as the shielding electrode within the sealing area, and
the power line comprises a first portion on the same layer as the first gate electrode and a second portion on the same layer as the dummy electrode within the sealing area, and
wherein the first portion and the second portion are electrically connected to each other through a contact hole that passes through an inorganic layer from among the plurality of inorganic layers and located between the first portion and the second portion.

11. The display device of any one of claims 7 to 10, wherein the first readout line comprises a first portion on the same layer as the shielding electrode within the sealing area, and
wherein the power line comprises a first portion on the same layer as the second gate electrode in the sealing area.

12. The display device of any one of claims 3 to 11, wherein the non-display area further comprises a bending area that is bent so that a portion of the base layer corresponding to the display area and a portion of the base layer corresponding to the pad area become close to each other, and
wherein the first data line, the first readout line, and the power line are on the same layer in the bending area;
optionally wherein the first readout line and the power line are on different layers in an area between the bending area and the pad area of the non-display area in the second direction.

13. The display device of claim 12, wherein the non-display area corresponding to the bending area has a width less than that of the non-display area corresponding to the pad area in the first direction.

14. The display device of any one of claims 1 to 13, further comprising:
a second pixel in the second area and comprising a second light emitting element;
a dummy data line extending from the chip area to the first area;
a second data line in the second area and electrically connected to the second light emitting element; and
a connection line electrically connecting the second data line to the dummy data line.

15. The display device of any one of claims 1 to 14, further comprising:
a second optical sensor in the first area;
a dummy readout line extending from the pad area to the second area;
a second readout line in the first area and electrically connected to the second optical sensor; and
a connection line electrically connecting the second readout line to the dummy readout line.
